(19) Europäisches Patentamt / European Patent Office / Office européen des brevets

(11) **EP 4 451 828 A1**

(12) **EUROPEAN PATENT APPLICATION**
published in accordance with Art. 153(4) EPC

(43) Date of publication:
**23.10.2024 Bulletin 2024/43**

(21) Application number: **23838642.9**

(22) Date of filing: **16.06.2023**

(51) International Patent Classification (IPC):
**H10K 59/10** *(2023.01)*

(86) International application number:
**PCT/CN2023/100570**

(87) International publication number:
**WO 2024/012148 (18.01.2024 Gazette 2024/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **14.07.2022 CN 202210823111**

(71) Applicants:
• **Boe Technology Group Co., Ltd.**
**Beijing 100015 (CN)**
• **Beijing BOE Technology Development Co., Ltd.**
**Beijing 100176 (CN)**

(72) Inventors:
• **XIAN, Jianbo**
**Beijing 100176 (CN)**
• **XU, Jingbo**
**Beijing 100176 (CN)**
• **WANG, Jingquan**
**Beijing 100176 (CN)**
• **QIAO, Yong**
**Beijing 100176 (CN)**
• **WU, Xinyin**
**Beijing 100176 (CN)**

(74) Representative: **Maiwald GmbH**
**Elisenhof**
**Elisenstraße 3**
**80335 München (DE)**

(54) **DISPLAY SUBSTRATE AND PREPARATION METHOD THEREFOR, AND DISPLAY APPARATUS**

(57)     A display substrate and a preparation method therefor, and a display apparatus. The display substrate comprises a plurality of sub-pixels, wherein a first sub-pixel comprises a first pixel circuit and a first effective light-emitting region; a second sub-pixel comprises a second pixel circuit and a second effective light-emitting region; a first light-shielding layer is provided between the first pixel circuit and a first base substrate, and the orthographic projection of the first light-shielding layer at least partially overlaps that of the first pixel circuit on the first base substrate; a second light-shielding layer is provided between the second pixel circuit and the first base substrate, and the orthographic projection of the second light-shielding layer at least partially overlaps that of the second pixel circuit on the first base substrate; the wavelength of light emitted from the first effective light-emitting region is greater than the wavelength of light emitted from the second effective light-emitting region, and the ratio M1 of the ratio a of the area of the first light-shielding layer to the area of the first sub-pixel to the ratio b of the area of the second light-shielding layer to the area of the second sub-pixel is 1.020-1.120. Aperture ratios corresponding to the first sub-pixel and the second sub-pixel are adjusted, so that the whole process can be simplified.

Fig. 2

EP 4 451 828 A1

**Description**

The present application claims the priority to a Chinese patent application with the number of 202210823111.7 submitted on July 14, 2022, and the entire contents of which are incorporated by reference in the present application.

TECHNICAL FIELD

Embodiments of the present disclosure relates to a display substrate and a manufacture method thereof, and a display device.

BACKGROUND

Display devices include thin film transistor liquid crystal displays (TFT-LCD), active-matrix organic light-emitting diode (AMOLED) display devices, etc. The active-matrix organic light-emitting diode (AMOLED) display devices have advantages of long lifespan, high display brightness, high contrast, and wide color gamut. Organic light-emitting diode display devices using the active-matrix organic light-emitting diodes as light-emitting elements not only have characteristics of being thinner and lighter than conventional liquid crystal display devices, but also have characteristics of fast response speed, wide viewing angle, and low voltage driving. Therefore, the organic light-emitting diode display devices can be widely used in cellular phones, portable information terminals, televisions, and monitors.

The organic light-emitting diode display device mainly includes a cathode, a light-emitting layer, and an anode. In the active-matrix organic light-emitting diode display device, each sub-pixel has a switching transistor and a driving transistor, by adjusting the switching transistor and the driving transistor, the light-emitting layer in the organic light-emitting diode display device emits light.

SUMMARY

At least one embodiment of the present disclosure provides a display substrate and a manufacture method thereof, and a display device. In the display substrate, the wavelength of light emitted from the first effective light-emitting region is greater than the wavelength of light emitted from the second effective light-emitting region, and the ratio M1 of the ratio a of the area of the first light-shielding layer corresponding to the first effective light-emitting region to the area of the first sub-pixel to the ratio b of the area of the second light-shielding layer corresponding to the second effective light-emitting region to the area of the second sub-pixel ranges from 1.020 to 1.120, that is, the area ratio of the light-shielding layer corresponding to the light with longer wavelength is larger and meets the range of the ratio M1 mentioned above, and the opening ratio of the display substrate can be adjusted.

At least one embodiment of the present disclosure provides a display substrate, and the display substrate includes: a first base substrate; and a plurality of sub-pixels on the first base substrate, the plurality of sub-pixels comprise a first sub-pixel and a second sub-pixel; the first sub-pixel comprises a first pixel circuit and a first effective light-emitting region; the second sub-pixel comprises a second pixel circuit and a second effective light-emitting region; a first light-shielding layer is provided between the first pixel circuit and the first base substrate, and an orthographic projection of the first light-shielding layer on the first base substrate at least partially overlaps with an orthographic projection of the first pixel circuit on the first base substrate; a second light-shielding layer is provided between the second pixel circuit and the first base substrate, and an orthographic projection of the second light-shielding layer on the first base substrate at least partially overlaps with an orthographic projection of the second pixel circuit on the first base substrate; a wavelength of light emitted from the first effective light-emitting region is greater than a wavelength of light emitted from the second effective light-emitting region, a ratio of an area of the first light-shielding layer to an area of the first sub-pixel is a, a ratio of an area of the second light-shielding layer to an area of the second sub-pixel is b, and a ratio M1 of a to b ranges from 1.020 to 1.120.

For example, in the display substrate provided by at least one embodiment of the present disclosure, the area of the first sub-pixel is equal to the area of the second sub-pixel; on a plane parallel to a main surface of the first base substrate, a ratio of the area of the first light-shielding layer to the area of the second light-shielding layer is equal to M1.

For example, in the display substrate provided by at least one embodiment of the present disclosure, an opening ratio of the first sub-pixel is $n1(1-a)$, and an opening ratio of the second sub-pixel is $n2(1-b)$; $(1-a)/(1-b)=(n2/n1) M2 * K1 * K2$, where K1 is a ratio of an initial brightness of the second sub-pixel to an initial brightness of the first sub-pixel, K2 is a ratio of a lifetime of the second sub-pixel to a lifetime of the first sub-pixel, and n1 is a ratio of an area of an opening region in the first sub-pixel to an area of a portion in the first sub-pixel other than a region shielded by the first light-shielding layer, n2 is a ratio of an area of an opening region in the second sub-pixel to an area of a portion in the second sub-pixel other than a region shielded by the second light-shielding layer, a value of $(n2/n1)M2$ ranges from 1.000 to 1.130, and a value of $(1-a)/(1-b)$ ranges from 0.877 to 0.997.

For example, in the display substrate provided by at least one embodiment of the present disclosure, the plurality of sub-pixels further comprise a third sub-pixel; the third sub-pixel comprises a third pixel circuit and a third effective light-emitting region; a third light-shielding layer is provided between the third pixel circuit and the first base substrate, and an orthographic projection of the third light-shielding layer on the first base substrate at least partially overlaps with an orthographic projection of the third pixel circuit on the first base substrate; a wavelength of light emitted from the third effective light-emitting region is greater than the wavelength of the light emitted from the second effective light-emitting region, on a plane parallel to a main surface of the first base substrate, an area ratio c of the third light-shielding layer is equal to a ratio of an area of the third light-shielding layer to an area of the third sub-pixel, and an opening ratio of the third sub-pixel is $n3(1-c)$; $(1-c)/(1-b)=(n2/n3)$ M3 * K3 * K4, where K3 is a ratio of an initial brightness of the second sub-pixel to an initial brightness of the third sub-pixel, K4 is a ratio of a lifetime of the second sub-pixel to a lifetime of the third sub-pixel, n3 is a ratio of an area of an opening region in the third sub-pixel to an area of a portion of the third sub-pixel other than a region shielded by the third light-shielding layer, a value of $(n2/n3)$ M3 ranges from 0.190 to 0.260, and a value of $(1-c)/(1-b)$ ranges from 1.002 to 1.350.

For example, in the display substrate provided by at least one embodiment of the present disclosure, the plurality of sub-pixels further comprise a fourth sub-pixel; the fourth sub-pixel comprises a fourth pixel circuit and a fourth effective light-emitting region; a fourth light-shielding layer is provided between the fourth pixel circuit and the first base substrate, and an orthographic projection of the fourth light-shielding layer on the first base substrate at least partially overlaps with an orthographic projection of the fourth pixel circuit on the first base substrate; a wavelength of light emitted from the fourth effective light-emitting region is greater than the wavelength of the light emitted from the second effective light-emitting region, on the plane parallel to the main surface of the first base substrate, an area ratio d of the fourth light-shielding layer is equal to a ratio of an area of the fourth light-shielding layer to an area of the fourth sub-pixel, an opening ratio $n4(1-d)$ of the fourth sub-pixel ranges from 0.230 to 0.950, where n4 is a ratio of an area of an opening region in the fourth sub-pixel to an area of a portion in the fourth sub-pixel other than a region shielded by the fourth light-shielding layer.

For example, in the display substrate provided by at least one embodiment of the present disclosure, the first sub-pixel further comprises a first light-emitting element, the first pixel circuit controls the first light-emitting element to emit light, and a color of light emitted by the first light-emitting element is same as a color of the light emitted from the first effective light-emitting region; the second sub-pixel further comprises a second light-emitting element, the second pixel circuit controls the second light-emitting element to emit light, and a color of light emitted by the second light-emitting element is same as a color of the light emitted from the second effective light-emitting region; and the third sub-pixel further comprises a third light-emitting element, the third pixel circuit controls the third light-emitting element to emit light, and a color of light emitted by the third light-emitting element is same as a color of the light emitted from the third effective light-emitting region.

For example, in the display substrate provided by at least one embodiment of the present disclosure, the first sub-pixel further comprises a first light-emitting element, and the first pixel circuit controls the first light-emitting element to emit light; the second sub-pixel further comprises a second light-emitting element, and the second pixel circuit controls the second light-emitting element to emit light; the third sub-pixel further comprises a third light-emitting element, and the third pixel circuit controls the third light-emitting element to emit light; the fourth sub-pixel further comprises a fourth light-emitting element, and the fourth pixel circuit controls the fourth light-emitting element to emit light; the first light-emitting element, the second light-emitting element, the third light-emitting element, and the fourth light-emitting element are all white light-emitting elements, and a first filter layer, a second filter layer, a third filter layer, and a light transmitting layer are respectively provided on sides of the first light-emitting element, the second light-emitting element, the third light-emitting element, and the fourth light-emitting element away from the first base substrate respectively; a color of light emitted from the first filter layer is same as a color of light emitted from the first effective light-emitting region, a color of light emitted from the second filter layer is same as a color of light emitted from the second effective light-emitting region, a color of light emitted from the third filter layer is same as a color of light emitted from the third effective light-emitting region, and a color of light emitted from the light transmitting layer is same as a color of light emitted from the fourth effective light-emitting region.

For example, in the display substrate provided by at least one embodiment of the present disclosure, a transmittance of a material of the first filter layer is $\lambda1$, a transmittance of a material of the second filter layer is $\lambda2$, a transmittance of a material of the third filter layer is $\lambda3$, and a transmittance of a material of the light transmitting layer is $\lambda4$; a total transmittance of the first filter layer, the second filter layer, the third filter layer, and the light transmitting layer is $T(\lambda)$, and $T(\lambda) = n1(1-a)\lambda1+n2(1-b)\lambda2+n3(1-c)\lambda3+n4(1-d)\lambda4$, and a value of $\lambda$ ranges from 0.260 to 0.950; a sum of the transmittances of the first filter layer, the second filter layer and the third filter layer and the transmittance of the light transmitting layer satisfy: $[n1(1-a)]\lambda1+n2(1-b)\lambda2+n3(1-c)\lambda3$ : $[n4(1-d)]\lambda4$ =1:1, and a value of $n4(1-d)$ ranges from 0.260 to 0.860.

For example, in the display substrate provided by at least one embodiment of the present disclosure, on the plane parallel to the main surface of the first base substrate, a ratio of a total of an area of the first filter layer, an area of the second filter layer, an area of the third filter layer, and an area of the light transmitting layer to a total of an area of the first light-shielding layer, an area of the second light-shielding layer, an area of the third light-shielding layer, and an area of the fourth light-shielding layer ranges from 1.050 to 6.800.

For example, in the display substrate provided by at least one embodiment of the present disclosure, on the plane parallel to the main surface of the first base substrate, a ratio of an area of the first filter layer to an area of the first light-shielding layer ranges from 2.000 to 3.000.

For example, in the display substrate provided by at least one embodiment of the present disclosure, on the plane parallel to the main surface of the first base substrate, a ratio of an area of the second filter layer to an area of the second light-shielding layer ranges from 1.1074 to 1.6938.

The display substrate provided by at least one embodiment of the present disclosure, further comprises: a data line and a first sensing line that extend along a first direction, and a second sensing line that extends along a second direction, and the data line intersects with the second sensing line to define a plurality of pixel regions, each of the plurality of pixel regions comprises the sub-pixel; a first power voltage line parallel to the data line is provided between adjacent sub-pixels, and a second power voltage line parallel to the second direction is provided on a side of the first effective light-emitting region close to the first light-shielding layer, the second power voltage line intersects with the first power voltage line and is connected to a first drain electrode of a first driving transistor in the first pixel circuit, and an orthographic projection of the second power voltage line on the first base substrate overlaps with an orthographic projection of the first light-shielding layer on the first base substrate.

For example, in the display substrate provided by at least one embodiment of the present disclosure, the orthographic projection of the second power voltage line on the first base substrate overlaps with the orthographic projection of the fourth light-shielding layer on the first base substrate.

For example, in the display substrate provided by at least one embodiment of the present disclosure, the orthographic projection of the second power voltage line on the first base substrate overlaps with an orthographic projection of the third light-shielding layer on the first base substrate, and overlaps with an orthographic projection of the second light-shielding layer on the first base substrate.

For example, in the display substrate provided by at least one embodiment of the present disclosure, an overlapping area of the orthographic projection of the second power voltage line on the first base substrate and the orthographic projection of the first light-shielding layer on the first base substrate is greater than an overlapping area of the orthographic projection of the second power voltage line on the first base substrate and the orthographic projection of the second light-shielding layer on the first base substrate.

For example, in the display substrate provided by at least one embodiment of the present disclosure, an overlapping area of the orthographic projection of the second power voltage line on the first base substrate and the orthographic projection of the first light-shielding layer on the first base substrate is greater than an overlapping area of the orthographic projection of the second power voltage line on the first base substrate and the orthographic projection of the third light-shielding layer on the first base substrate.

For example, in the display substrate provided by at least one embodiment of the present disclosure, an overlapping area of the orthographic projection of the second power voltage line on the first base substrate and the orthographic projection of the first light-shielding layer on the first base substrate is greater than an overlapping area of the orthographic projection of the second power voltage line on the first base substrate and the orthographic projection of the fourth light-shielding layer on the first base substrate; the overlapping area of the orthographic projection of the second power voltage line on the first base substrate and the orthographic projection of the fourth light-shielding layer on the first base substrate is greater than the overlapping area of the orthographic projection of the second power voltage line on the first base substrate and the orthographic projection of the third light-shielding layer on the first base substrate; the overlapping area of the orthographic projection of the second power voltage line on the first base substrate and the orthographic projection of the third light-shielding layer on the first base substrate is greater than the overlapping area of the orthographic projection of the second power voltage line on the first base substrate and the orthographic projection of the second light-shielding layer on the first base substrate.

For example, in the display substrate provided by at least one embodiment of the present disclosure, in one first sub-pixel, an overlapping area of the orthographic projection of the second power voltage line on the first base substrate and the orthographic projection of the first light-shielding layer on the first base substrate ranges from 0.03 square micrometers to 0.30 square micrometers; in one second sub-pixel, an overlapping area of the orthographic projection of the second power voltage line on the first base substrate and the orthographic projection of the fourth light-shielding layer on the first base substrate ranges from 0.02 square micrometers to 0.20 square micrometers; in one third sub-pixel, an overlapping area of the orthographic projection of the second power voltage line on the first base substrate and the orthographic projection of the third light-shielding layer on the first base substrate ranges from 0 to 0.05 square micrometers; and in one fourth sub-pixel, an overlapping area of the orthographic projection of the second power voltage line on the first base substrate and the orthographic projection of the second light-shielding layer on the first base substrate ranges from 0 to 0.08 square micrometers.

For example, in the display substrate provided by at least one embodiment of the present disclosure, the second power voltage line comprises a first portion and a second portion that are separated from each other, and the first portion and the second portion are connected to the first power voltage line through different via structures.

For example, in the display substrate provided by at least one embodiment of the present disclosure, the first portion is connected to the first drain electrode of the first driving transistor of the first pixel circuit and a second drain electrode of a second driving transistor of the second pixel circuit; the second portion is connected to a third drain electrode of a third driving transistor of the third pixel circuit and a fourth drain electrode of a fourth driving transistor of the fourth pixel circuit.

For example, in the display substrate provided by at least one embodiment of the present disclosure, an extension direction of the first portion is parallel to an extension direction of the second portion, the first portion and the second portion extend in a straight line, and the first portion is on a side of the second portion close to the second sensing line.

For example, in the display substrate provided by at least one embodiment of the present disclosure, the first portion is connected to the first drain electrode and a middle region of the second drain electrode, and the second portion is connected to an edge of the third drain electrode away from the second sensing line and an edge of the fourth drain electrode away from the second sensing line.

For example, in the display substrate provided by at least one embodiment of the present disclosure, the first portion and the second portion both extend along a broken line, and the first portion is connected to an edge of the first drain electrode away from the second sensing line and a middle region of the second drain electrode; the second portion is connected to an edge of the third drain electrode away from the second sensing line and a middle region of the fourth drain electrode.

For example, in the display substrate provided by at least one embodiment of the present disclosure, the first drain electrode and the first light-shielding layer are connected through a first via that sequentially penetrates an interlayer insulation layer, a gate insulation layer, and a buffer layer.

The display substrate provided by at least one embodiment of the present disclosure, further comprises a first gate line extending along the second direction and a first gate electrode extending from the first gate line towards a side of the second power voltage line, in which a planar shape of the first light-shielding layer comprises a first sub-portion and a second sub-portion extending along the first direction, and a first distance between a first side of the first sub-portion close to the first gate line and the first gate line is greater than a second distance between a second side of the second sub-portion close to the first gate electrode and the first gate electrode.

The display substrate provided by at least one embodiment of the present disclosure, further comprises a second gate line parallel to the first gate line, in which the first gate electrode is configured as a gate electrode of a first switching transistor, the second gate line is configured as a gate electrode of a first sensing transistor of the first pixel circuit, a gate electrode of a second sensing transistor of the second pixel circuit, a gate electrode of a third sensing transistor of the third pixel circuit, and a gate electrode of a fourth sensing transistor of the fourth pixel circuit.

At least one embodiment of the present disclosure further provides a display device, and the display device comprises the display substrate according to any one of the embodiments mentioned above and a cover plate opposite to the display substrate, the cover plate comprises a second base substrate, and a quantum dot layer is provided on a side of the second base substrate close to the display substrate, the quantum dot layer comprises a plurality of quantum dot units, the plurality of quantum dot units correspond to a plurality of sub-pixels in one-to-one correspondence, a color of each of the plurality of quantum dot units is same as a color of a corresponding sub-pixel.

The display device provided by at least one embodiment of the present disclosure, further comprises a black matrix provided on the side of the second base substrate close to the display substrate, and the black matrix comprises a plurality of openings, and each of the plurality of quantum dot units is within one of the plurality of openings.

At least one embodiment of the present disclosure further provides a manufacture method of a display substrate, and the manufacture method comprises: providing a first base substrate; and forming a plurality of sub-pixels on the first base substrate, in which forming the plurality of sub-pixels comprises forming a first sub-pixel and a second sub-pixel; forming the first sub-pixel comprises forming a first pixel circuit and a first effective light-emitting region; forming the second sub-pixel comprises forming a second pixel circuit and a second effective light-emitting region; forming a first light-shielding layer between the first pixel circuit and the first base substrate, and an orthographic projection of the first light-shielding layer on the first base substrate at least partially overlaps with an orthographic projection of the first pixel circuit on the first base substrate; forming a second light-shielding layer between the second pixel circuit and the first base substrate, in which an orthographic projection of the second light-shielding layer on the first base substrate at least partially overlaps with an orthographic projection of the second pixel circuit on the first base substrate; a wavelength of light emitted from the first effective light-emitting region is greater than a wavelength of light emitted from the second effective light-emitting region, a ratio of an area of the first light-shielding layer to an area of the first sub-pixel is a, a ratio of an area of the second light-shielding layer to an area of the second sub-pixel is b, and a ratio M1 of a to b ranges from 1.020 to 1.120.

In the manufacture method provided by at least one embodiment of the present disclosure, an opening ratio of the first sub-pixel is n1(1-a), and an opening ratio of the second sub-pixel is n2(1-b); (1-a)/(1-b)=(n2/n1) M2 * K1 * K2, where K1 is a ratio of an initial brightness of the second sub-pixel to an initial brightness of the first sub-pixel, K2 is a ratio of a lifetime of the second sub-pixel to a lifetime of the first sub-pixel, and n1 is a ratio of an area of an opening region in the first sub-pixel to an area of a portion in the first sub-pixel other than a region shielded by the first light-shielding layer, n2 is a ratio of an area of an opening region in the second sub-pixel to an area of a portion in the second sub-pixel other than a region shielded by the second light-shielding layer, a value of (n2/n1)M2 ranges from 1.000 to 1.130, and a value of (1-a)/(1-b) ranges from 0.877 to 0.997.

BRIEF DESCRIPTION OF DRAWINGS

In order to clearly illustrate the technical solution of the embodiments of the present disclosure, the drawings of the embodiments will be briefly described. It is obvious that the described drawings in the following are only related to some embodiments of the present disclosure and thus are not construed as any limitation to the present disclosure.

Fig. 1 is a planar structural schematic diagram of a display substrate provided by at least one embodiment of the present disclosure;
Fig. 2 is a planar structural schematic diagram of another display substrate provided by at least one embodiment of the present disclosure;
Fig. 3 is a planar structural schematic diagram of further another display substrate provided by at least one embodiment of the present disclosure;
Fig. 4 is a planar structural schematic diagram of further another display substrate provided by at least one embodiment of the present disclosure;
Fig. 5 is a planar structural schematic diagram of further another display substrate provided by at least one embodiment of the present disclosure;
Fig. 6 is a planar structural schematic diagram of further another display substrate provided by at least one embodiment of the present disclosure;
Fig. 7 is a planar structural schematic diagram of further another display substrate provided by at least one embodiment of the present disclosure;
Fig. 8A is a cross-sectional structural schematic diagram of the display substrate in Fig. 1 to Fig. 3 along a line A-A';
Fig. 8B is a cross-sectional structural schematic diagram of the display substrate in Fig. 4 along a line B-B' and a line C-C';
Fig. 9 is a planar structural schematic diagram of further another display substrate provided by at least one embodiment of the present disclosure;
Fig. 10 is a planar structural schematic diagram of further another display substrate provided by at least one embodiment of the present disclosure;
Fig. 11 is a planar structural schematic diagram of further another display substrate provided by at least one embodiment of the present disclosure;
Fig. 12 is a schematic diagram of a 3T1C pixel circuit for a display substrate provided by at least one embodiment of the present disclosure;
Fig. 13 is a signal timing diagram of the pixel circuit in Fig. 12 during a display process;
Fig. 14 is a first signal timing diagram of the pixel circuit in Fig. 12 during a detection process;
Fig. 15 is a second signal timing diagram of the pixel circuit in Fig. 12 during a detection process;
Fig. 16 is a cross-sectional structural schematic diagram of a display device provided by at least one embodiment of the present disclosure;
Fig. 17 is a flowchart of a manufacture method of a display substrate provided by at least one embodiment of the present disclosure; and
Fig. 18A to Fig. 18H are formation process diagram of a first sub-pixel provided by at least one embodiment of the present disclosure.

DETAILED DESCRIPTION

In order to make objectives, technical details, and advantages of the embodiments of the present disclosure more clear, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first", "second", etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to define a physical connection or mechanical connection, but may include an electrical connection, directly or indirectly. "Up", "down", "left", "right", and so on are only used to represent relative positional relationships. When the absolute position of the described object changes, the relative positional relationship may also change accordingly.

As the resolution of the light-emitting diode display devices increases, the pixel size of the light-emitting diode display devices continuously decreas. In the light-emitting diode display devices, the brightness of the red sub-pixel, the brightness of the green sub-pixel, and the brightness of the blue sub-pixel are inconsistent, and the wavelengths of the light respectively emitted by the red sub-pixel, the green sub-pixel, and the blue sub-pixel are different. Therefore, it is necessary to adjust the opening ratio of the sub-pixels of different colors to improve the light mixing effect of the red sub-pixel, the green sub-pixel, and the blue sub-pixel. For the light-emitting elements emitting white light or blue light, filter layers should be provided in the corresponding regions of the red sub-pixel, the green sub-pixel, and the blue sub-pixel. As the pixel size in the light-emitting diode display device decreases, the distance between the filter layers corresponding to the sub-pixels of different colors decreases, which easily leads to color crosstalk, and increases the difficulty of adjusting the opening ratio of the red sub-pixel, the green sub-pixel, and the blue sub-pixel by adjusting the size of the filter layers. The inventor(s) of the present disclosure found that the opening ratio corresponding to different sub-pixels can be adjusted by designing the size of the light-shielding layer corresponding to different sub-pixels, thereby making the entire manufacture process of the display substrate simpler.

At least one embodiment of the present disclosure provides a display substrate, the display substrate includes: a first base substrate; and a plurality of sub-pixels on the first base substrate, in which the plurality of sub-pixels include a first sub-pixel and a second sub-pixel; the first sub-pixel includes a first pixel circuit and a first effective light-emitting region; the second sub-pixel includes a second pixel circuit and a second effective light-emitting region; a first light-shielding layer is provided between the first pixel circuit and the first base substrate, and an orthographic projection of the first light-shielding layer on the first base substrate at least partially overlaps with an orthographic projection of the first pixel circuit on the first base substrate; a second light-shielding layer is provided between the second pixel circuit and the first base substrate, and an orthographic projection of the second light-shielding layer on the first base substrate at least partially overlaps with an orthographic projection of the second pixel circuit on the first base substrate; a wavelength of light emitted from the first effective light-emitting region is greater than a wavelength of light emitted from the second effective light-emitting region, a ratio of an area of the first light-shielding layer to an area of the first sub-pixel is a, a ratio of an area of the second light-shielding layer to an area of the second sub-pixel is b, and a ratio M1 of a to b ranges from 1.020 to 1.120. The embodiments of the present disclosure adjust the opening ratio of different sub-pixels by designing the size of the light-shielding layer corresponding to the different sub-pixels, thereby making the entire manufacture process of the display substrate simpler.

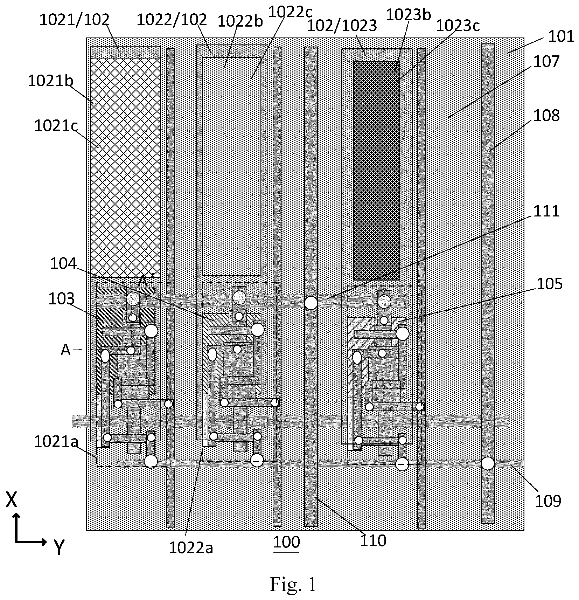

Fig. 1 is a planar structural schematic diagram of a display substrate provided by at least one embodiment of the present disclosure, as shown in Fig. 1, the display substrate 100 includes: a first base substrate 101 and a plurality of sub-pixels 102 on the first base substrate 101. The arrangement direction of the plurality of sub-pixels 102 is a second direction Y, that is, the plurality of sub-pixels 102 are arranged side by side in the second direction Y. The plurality of sub-pixels 102 include a first sub-pixel 1021 and a second sub-pixel 1022 arranged side by side in the second direction Y, and a direction that intersects or is perpendicular to the second direction Y is a first direction X. The first sub-pixel 1021 includes a first pixel circuit 1021a and a first effective light-emitting region 1021b in the first direction X; the second sub-pixel 1022 includes a second pixel circuit 1022a and a second effective light-emitting region 1022b in the first direction X. In a direction perpendicular to the main surface of the first base substrate 101, a first light-shielding layer 103 is provided between the first pixel circuit 1021a and the first base substrate 101, and an orthographic projection of the first light-shielding layer 103 on the first base substrate 101 at least partially overlaps with an orthographic projection of the first pixel circuit 1021a on the first base substrate 101. A second light-shielding layer 104 is provided between the second pixel circuit 1022a and the first base substrate 101, and an orthographic projection of the second light-shielding layer 104 on the first base substrate 101 at least partially overlaps with an orthographic projection of the second pixel circuit 1022a on the first base substrate 101. For example, a wavelength of light emitted from the first effective light-emitting region 1021b is greater than a wavelength of light emitted from the second effective light-emitting region 1022b, the ratio of the area of the first light-shielding layer 103 to the area of the first sub-pixel 1021 is a, the ratio of the area of the second light-shielding layer 104 to the area of the second sub-pixel 1022 is b, and the ratio M1 of a to b ranges from 1.020 to 1.120. In the case that the ratio M1 of a to b is less than 1.020, the ratio a of the area of the first light-shielding layer 103 to the area of the first sub-pixel 1021 is too small, resulting in a higher opening ratio of the first sub-pixel 1021 and a lower opening ratio of the second sub-pixel 1022, which leads to poor final color mixing effect. In the case that the ratio M1 of a to b is greater than 1.120, the ratio a of the area of the first light-shielding layer 103 to the area of the first sub-pixel 1021 is too large, resulting in a lower opening rate of the first sub-pixel 1021 and a higher opening rate of the second sub-pixel 1022, which leads to poor final color mixing effect. In addition, in the case that the ratio M1 of a to b is less than 1.020, the ratio a of the area of the first light-shielding layer 103 to the area of the first sub-pixel 1021 is smaller, causing the first light-shielding layer 103 corresponding to the first sub-pixel 1021 to be smaller, the shielding protection effect on the first pixel circuit 1021a is relatively weak (for example, the first light-shielding layer 103 at least overlaps with the active layer of the driving transistor of the first pixel circuit 1021a to provide shielding protection and avoid leakage current caused by external light irradiation). In the case that the ratio M1 of a to b is greater than 1.120, the second light-shielding layer 104 corresponding to the second sub-pixel 1022 is smaller, which weakens the shielding protection effect on the second pixel circuit 1022a (for example, the first light-shielding layer 103 at least overlaps with the active layer of the driving transistor of the second pixel circuit 1022a to provide shielding protection and avoid leakage current caused by external light irradiation).

For example, the first sub-pixel and the second sub-pixel included in the plurality of sub-pixels may be two adjacent sub-pixels arranged side by side along the second direction in one pixel unit, or two sub-pixels arranged side by side and spaced apart from each other along the second direction in one pixel unit. The embodiments of the present disclosure are not limited in this aspect, as long as the first sub-pixel and the second sub-pixel are in the same pixel unit.

For example, in one example, the first sub-pixel 1021 and the second sub-pixel 1022 are respectively red sub-pixel and green sub-pixel, correspondingly, the first effective light-emitting region 1021b is a red light-emitting region, and the second effective light-emitting region 1022b is a green light-emitting region. Generally, the light-emitting region of the red sub-pixel is larger than the light-emitting region of the green sub-pixel, that is, the area of the first effective light-emitting region 1021b is larger than the area of the second effective light-emitting region 1022b, by providing the area of the first light-shielding layer 103 to be larger than the area of the second light-shielding layer 104, the opening ratio of the first sub-pixel 1021 and the second sub-pixel 1022 can be adjusted to improve the final mixing effect. Moreover, the manufacture process of the display substrate is simpler, and the display substrate has higher light-emitting efficiency. In addition, because the wavelength of the light emitted from the red sub-pixel is greater than the wavelength of the light emitted from the green sub-pixel, the red sub-pixel is more prone to diffraction, which in turn affects the pixel circuit of the same sub-pixel or other sub-pixels. Therefore, the area of the first light-shielding layer 103 is provided to be larger than the area of the second light-shielding layer 104 to decrease the diffraction of the light emitted from the red sub-pixel.

For example, the first light-shielding layer 103 and the second light-shielding layer 104 can be formed using the same material in the same process. The materials of the first light-shielding layer 103 and the second light-shielding layer 104 can be metal materials with shading performance or other materials with shading performance, which is not limited by the embodiments of the present disclosure.

For example, as shown in Fig. 1, the orthographic projection of the first effective light-emitting region 1021b on the first base substrate 101 does not overlap with the orthographic projection of the first light-shielding layer 103 on the first base substrate 101, and the orthographic projection of the second effective light-emitting region 1022b on the first base substrate 101 does not overlap with the orthographic projection of the second light-shielding layer 104 on the first base substrate 101. In the case that the display substrate is used in a display panel, the display panel can achieve top emission, bottom emission or bidirectional emission, the embodiments of the present disclosure are not limited in this aspect.

For example, as shown in Fig. 1, in one example, a is equal to the area of the first light-shielding layer/the area of the first sub-pixel, b is equal to the area of the second light-shielding layer/the area of the second sub-pixel, M1=a/b. In one example, the area of the first sub-pixel 1021 is equal to the area of the second sub-pixel 1022, and on a plane parallel to the main surface of the first base substrate 101, the ratio of the area of the first light-shielding layer 103 to the area of the second light-shielding layer 104 is equal to M1.

For example, as shown in Fig. 1, the region shielded by the first light-shielding layer 103 is not an opening region, and in addition to the region shielded by the first light-shielding layer 103 and the opening region, the first sub-pixel 1021 also includes other regions. The region shielded by the second light-shielding layer 104 is not an opening region, and in addition to the region shielded by the second light-shielding layer 104 and the opening region, the second sub-pixel 1022 also includes other regions. The opening ratio of the first sub-pixel 1021 is n1 (1-a), where n1 is the ratio of the area of the opening region in the first sub-pixel 1021 to the area of the portion in the first sub-pixel 1021 other than the region shielded by the first light-shielding layer 103. The opening ratio of the second sub-pixel is n2 (1-b), where n2 is the ratio of the area of the opening region in the second sub-pixel 1022 to the area of the portion in the second sub-pixel 1022 other than the region shielded by the second light-shielding layer 104. (n1/n2) (1-a)/(1-b) = M2 * K1 * K2, that is (1-a)/(1-b) = (n2/n1) M2 * K1 * K2, where K1 is the ratio of the initial brightness of the second sub-pixel to the initial brightness of the first sub-pixel, K2 is the ratio of the lifetime of the second sub-pixel to the lifetime of the first sub-pixel, a value of (n2/n1) M2 ranges from 1.000 to 1.130, and a value of (1-a)/(1-b) ranges from 0.877 to 0.997.

For example, the above formula (n1/n2) (1-a)/(1-b) = M2 * K1 * K2 is derived using the following formula: (initial brightness of the sub-pixel * the opening rate of the pixel/initial brightness of the pixel unit) * luminescence lifetime of the sub-pixel = C constant.

(Initial brightness of the first sub-pixel * the opening rate of the first sub-pixel)/initial brightness of the pixel unit) * luminescence lifetime of the first sub-pixel=M2 * (initial brightness of the second sub-pixel * the opening rate of the second sub-pixel)/initial brightness of the pixel unit) * luminescence lifetime of the second sub-pixel.

Further derivation: (the opening ratio of the first sub-pixel)/(the opening ratio of the second sub-pixel)=M2 * (initial brightness of the second sub-pixel/initial brightness of the pixel unit) * luminescence lifetime of the second sub-pixel)/(initial brightness of the first sub-pixel/initial brightness of the pixel unit) * luminescence lifetime of the first sub-pixel), if the first sub-pixel and the second sub-pixel correspond to the same pixel unit, the initial brightness of the pixel unit corresponding to the first sub-pixel is equal to the initial brightness of the pixel unit corresponding to the second sub-pixel, the above formula can be simplified as formula (I):

(The opening rate of the first sub-pixel)/(the opening rate of the second sub-pixel)=M2 * (initial brightness of the second sub-pixel * luminescence lifetime of the second sub-pixel)/(initial brightness of the first sub-pixel * luminescence lifetime of the first sub-pixel).

Substitute the opening ratio of the first sub-pixel=n1 (1-a) and the opening ratio of the second sub-pixel=n2 (1-b) into formula (I) to obtain the following formula (II):

(The opening ratio of the first sub-pixel)/(the opening ratio of the second sub-pixel)=(n1/n2)(1-a)/(1-b)=M2 * (initial brightness of the second sub-pixel * luminescence lifetime of the second sub-pixel)/(initial brightness of the first sub-pixel * luminescence lifetime of the first sub-pixel).

The following formula can be obtained through formula (II): (1-a)/(1-b)=(n2/n1) M2 * ((initial brightness of the second sub-pixel * luminescence lifetime of the second sub-pixel)/(initial brightness of the first sub-pixel * luminescence lifetime of the first sub-pixel))=(n2/n1) M2 * K1 * K2, where K1=initial brightness of the second sub-pixel/initial brightness of first sub-pixel, K2=luminescence lifetime of the second sub-pixel/luminescence lifetime of the first sub-pixel, for example, in one example, (n2/n1)M2=1.00~1.130. For example, when n2=n1, M2=1.00~1.130.

For example, in one example, the initial brightness of the first sub-pixel is 26.1cd/m$^2$, the initial brightness of the second sub-pixel is 86.1cd/m$^2$, the luminescence lifetime of the first sub-pixel is 150000 hours, the luminescence lifetime of the second sub-pixel is 40000 hours, n2=n1, M2=1.130, then it can be calculated that: (1-a)/(1-b)=1.13 * (86.1cd/m$^2$ * 40000 hours)/(26.1cd/m$^2$ * 150000 hours))=0.994. The initial brightness can be obtained by testing the brightness of each sub-pixel in a display device under a certain grayscale condition. For example, in the 255 grayscale of the display device, perform the brightness test on each sub-pixel. For example, the wavelength of the light emitted by the second sub-pixel is shorter, the initial brightness of the second sub-pixel is higher, and the lifetime is shorter; the wavelength of the light emitted by the first sub-pixel is longer, the initial brightness of the first sub-pixel is lower, and the lifetime is longer. Therefore, it can be obtained that K1 is smaller than K2.

For example, in one example, the first sub-pixel is a red sub-pixel, and the second sub-pixel is a green sub-pixel. Generally, the initial brightness of the green sub-pixel is higher, and the lifetime of the green sub-pixel is shorter. The initial brightness of the red sub-pixel is lower, and the lifetime of the red sub-pixel is longer. Therefore, K1 is smaller than K2.

For example, in the structure shown in Fig. 1, the plurality of sub-pixels 102 further include a third sub-pixel 1023, that is, the third sub-pixel 1023 is further provided on the first base substrate 101 and the third sub-pixel 1023 is arranged side by side with the first sub-pixel 1021 and the second sub-pixel 1022. The third sub-pixel 1023 may include a third pixel circuit 1023a and a third effective light-emitting region 1023b.

For example, a third light-shielding layer 105 is provided between the third pixel circuit 1023a and the first base substrate 101, and an orthographic projection of the third light-shielding layer 105 on the first base substrate 101 at least partially overlaps with an orthographic projection of the third pixel circuit 1023a on the first base substrate 101. The wavelength of the light emitted from the third effective light-emitting region 1023b is smaller than the wavelength of the light emitted from the second effective light-emitting region 1022b, and on a plane parallel to the main surface of the first base substrate 101, an area ratio c of the third light-shielding layer 105 is equal to a ratio of the area of the third light-shielding layer 105 to the area of the third sub-pixel 1023, and the opening ratio of the third sub-pixel 1023 is n3 (1-c).

Similarly, according to the derivation process of (1-a)/(1-b)=(n2/n1) M2 * K1 * K2, it can be derived that: (1-c)/(1-b)=(n2/n3) M3 * K3 * K4, where K3 is a ratio of the initial brightness of the second sub-pixel to the initial brightness of the third sub-pixel, K4 is a ratio of the lifetime of the second sub-pixel to the lifetime of the third sub-pixel, n3 is a ratio of the area of the opening region in the third sub-pixel to the area of the portion in the third sub-pixel other than the region shielded by the third light-shielding layer, and a value of (n2/n3) M3 ranges from 0.190 to 0.260, and a value of (1-c)/(1-b) ranges from 1.002 to 1.350.

For example, the first effective light-emitting region 1021b, the second effective light-emitting region 1022b, and the third effective light-emitting region 1023b respectively correspond to the red light-emitting region, the green light-emitting region, and the blue light-emitting region, and correspondingly, the first sub-pixel 1021, the second sub-pixel 1022, and the third sub-pixel 1023 are respectively the red sub-pixel, the green sub-pixel, and the blue sub-pixel.

For example, in one example, the initial brightness of the second sub-pixel 1022 is 86.1cd/m$^2$, the luminescence lifetime of the second sub-pixel 1022 is 40000 hours, and the initial brightness of the third sub-pixel 1023 is 11.3cd/m$^2$, the luminescence lifetime of the third sub-pixel 1023 is 60000 hours, n2=n3, M3=0.260, then it can be calculated that: (1-c)/(1-b) = 0.260 * (86.1cd/m2 * 40000 hours)/(11.3cd/m2 * 60000 hours))=1.32.

For example, as shown in Fig. 1, the first sub-pixel 1021 further includes a first light-emitting element 1021c, the first pixel circuit 1021a controls the first light-emitting element 1021c to emit light, and the color of the light emitted by the first light-emitting element 1021c is the same as the color of the light emitted from the first effective light-emitting region 1021b. The second sub-pixel 1022 further includes a second light-emitting element 1022c, and the second pixel circuit 1022a controls the second light-emitting element 1022c to emit light, and the color of the light emitted by the second light-emitting element 1022c is the same as the color of the light emitted from the second effective light-emitting region 1022b. The third sub-pixel 1023 further includes a third light-emitting element 1023c, and the third pixel circuit 1023a controls the third light-emitting element 1023c to emit light, and the color of the light emitted by the third light-emitting element 1023c is the same as the color of the light emitted from the third effective light-emitting region 1023b. For example, the first emitting element 1021c, the second emitting element 1022c, and the third emitting element 1023c respectively emit first color light, second color light, and third color light, and the first color light, the second color light, and the third color light can be mixed to form white light.

For example, in one example, the first emitting element, the second emitting element, and the third emitting element respectively emit red light, green light, and blue light.

For example, in one example, the area of the first light-shielding layer 103 corresponding to the red sub-pixel > the area of the second light-shielding layer 104 corresponding to the green sub-pixel > the area of the third light-shielding layer 105 corresponding to the blue sub-pixel. For example, the area of the first light-shielding layer 103: the area of the second light-shielding layer 104: the area of the third light-shielding layer 105=20:19:18. Because of the fact that the wavelength of the light emitted from the red pixel > the wavelength of the light emitted from the green sub-pixel > the wavelength of the light emitted from the blue sub-pixel, the longer the wavelength, the more likely diffraction occurs, which in turn affects the pixel circuit of the same sub-pixel or other sub-pixels. Therefore, sub-pixels with longer wavelengths correspond to larger light-shielding layers, to slow down the diffraction effect of the emitted light. For example, in one example, the area of the first light-shielding layer 103 corresponding to the red sub-pixel > the area of the second light-shielding layer 104 corresponding to the green sub-pixel >the area of the third light-shielding layer 105 corresponding to the blue sub-pixel. For example: a: b: c=20:19:18.

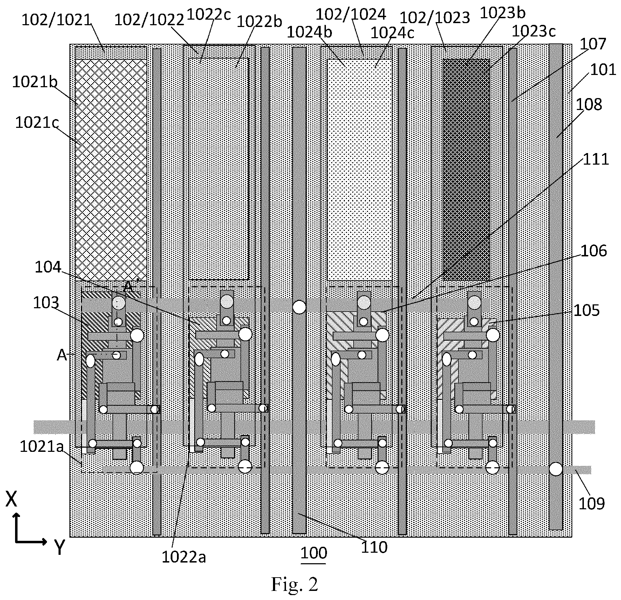

For example, Fig. 2 is a planar structural schematic diagram of another display substrate provided by at least one embodiment of the present disclosure, as shown in Fig. 2, compared to the structure of the display substrate shown in Fig. 1, in the structure shown in Fig. 2, the plurality of sub-pixels 102 further include a fourth sub-pixel 1024, that is, the fourth sub-pixel 1024 is further provided on the first base substrate 101 and arranged side by side with the first sub-pixel 1021, the second sub-pixel 1022, and the third sub-pixel 1023.

It should be noted that although in Fig. 2, the first sub-pixel 1021, the second sub-pixel 1022, the fourth sub-pixel 1024, and the third sub-pixel 1023 are arranged side by side, the embodiments of the present disclosure are not limited to this. The third sub-pixel 1023 may also be provided between the second sub-pixel 1022 and the fourth sub-pixel 1024 or arranged in other order, which is not limited by the embodiments of the present disclosure.

For example, the relevant features of the first sub-pixel 1021, the second sub-pixel 1022, and the third sub-pixel 1023 can be referred to the above descriptions of Fig. 1.

For example, as shown in Fig.2, the fourth sub-pixel 1024 includes a fourth pixel circuit 1024a and a fourth effective light-emitting region 1024b. A fourth light-shielding layer 106 is provided between the fourth pixel circuit 1024a and the first base substrate 101, and an orthographic projection of the fourth light-shielding layer 106 on the first base substrate 101 at least partially overlaps with an orthographic projection of the fourth pixel circuit 1024a on the first base substrate 101. The wavelength of the light emitted from the fourth effective light-emitting region 1024b is greater than the wavelength of the light emitted from the second effective light-emitting region 1022b, and on a plane parallel to the main surface of the first base substrate 101, the area ratio d of the fourth light-shielding layer 106 is equal to the ratio of the area of the fourth light-shielding layer 106 to the area of the fourth sub-pixel 1024. The opening ratio n4 (1-d) of the fourth sub-pixel 1024 ranges from 0.230 to 0.950, where n4 is the ratio of the area of the opening region in the fourth sub-pixel to the area of the portion in the fourth sub-pixel other than the region shielded by the fourth light-shielding layer.

For example, in one example, the light emitted from the fourth sub-pixel 1024 is white light, that is, the fourth sub-pixel 1024 is a white sub-pixel, and correspondingly, the fourth effective light-emitting region 1024b is a white light-emitting region.

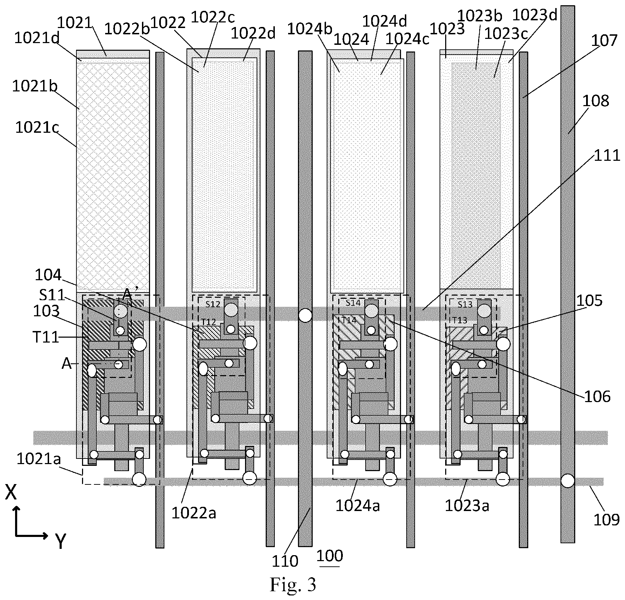

Fig. 3 is a planar structural schematic diagram of further another display substrate provided by at least one embodiment of the present disclosure, as shown in Fig. 3, the first sub-pixel 1021 includes a first light-emitting element 1021c, and the first pixel circuit 1021a controls the first light-emitting element 1021c to emit light. The second sub-pixel 1022 also includes a second light-emitting element 1022c, and the second pixel circuit 1022a controls the second light-emitting element 1022c to emit light. The third sub-pixel 1023 also includes a third light-emitting element 1023c, and the third pixel circuit 1023a controls the third light-emitting element 1023c to emit light. The fourth sub-pixel 1024 also includes a fourth light-emitting element 1024c, and the fourth pixel circuit 1024a controls the fourth light-emitting element 1024c to emit light. The first emitting element 1021c, the second emitting element 1022c, the third emitting element 1023c, and the fourth emitting element 1024c are all white emitting elements, and a first filter layer 1021d, a second filter layer 1022d, a third filter layer 1023d, and a light transmitting layer 1024d are respectively provided on the sides of the first emitting element 1021c, the second emitting element 1022c, the third emitting element 1023c, and the fourth emitting element 1024c away from the first base substrate 101. The color of the light emitted from the first filter layer 1021d is the same as the color of the light emitted from the first effective light-emitting region 1021b, the color of the light emitted from the second filter layer 1022d is the same as the color of the light emitted from the second effective light-emitting region 1022b, the color of the light emitted from the third filter layer 1023d is the same as the color of the light emitted from the third effective light-emitting region 1023b, and the color of the light emitted from the light transmitting layer 1024d is the same as the color of the light emitted from the fourth effective light-emitting region 1024b, which is still white light.

It should be noted that for the sake of simplicity in the illustration, the first base substrate 101 has been omitted in Fig. 3.

For example, as shown in Fig. 3, the transmittance of the material of the first filter layer 1021d is $\lambda 1$, the transmittance of the material of the second filter layer 1022d is $\lambda 2$, the transmittance of the material of the third filter layer 1023d is $\lambda 3$, and the transmittance of the material of the light transmitting layer 1024d is $\lambda 4$. The total transmittance of the first filter layer 1021d, the second filter layer 1022d, the third filter layer 1023d, and the light transmitting layer 1024d is $T(\lambda)$, $T(\lambda)$ = N1 (1-a) $\lambda 1$+n2 (1-b) $\lambda 2$+n3 (1-c) $\lambda 3$+n4 (1-d) $\lambda 4$, and the value of 4 ranges from 0.260 to 0.950. The sum of the transmittance of the first filter layer 1021d, the transmittance of the second filter layer 1022d, and the transmittance of the third filter layer 1023d satisfies the following proportional relationship with the transmittance of the light transmitting layer 1024d: [n1 (1-a)] $\lambda 1$+n2 (1-b) $\lambda 2$+n3 (1-c) $\lambda 3$] : [n4 (1-d)] $\lambda 4$] =1: 1, and the value of n4 (1-d) ranges from 0.260 to 0.860, where n4 is the ratio of the area of the opening region in the fourth sub-pixel 1024 to the area of the portion in the fourth sub-pixel 1024 other than the region shielded by the fourth light-shielding layer 106.

For example, the first light-emitting element 1021c, the second light-emitting element 1022c, the third light-emitting element 1023c, and the fourth light-emitting element 1024c are all light-emitting elements that emit white light. This design can improve the uniformity of the emitted light, and the white light can adjust the width of the spectrum, and perform optical compensation.

For example, in one example, on a plane parallel to the main surface of the first base substrate 101, the ratio of the total of an area of the first filter layer 1021d, an area of the second filter layer 1022d, an area of the third filter layer 1023d, and an area of the light transmitting layer 1024d to the total of an area of the first light-shielding layer 103, an area of the second light-shielding layer 104, an area of the third light-shielding layer 105, and an area of the fourth light-shielding layer 106 ranges from 1.050 to 6.800, for example, the ratio may be 1.100, 1.200, 2.000, 2.500, 3.000, 3.500, 4.000, 4.500, 5.000, 5.500, 6.000, 6.500, which is not limited by the embodiments of the present disclosure.

For example, in another example, on a plane parallel to the main surface of the first base substrate 101, the ratio of the total area of the first filter layer 1021d, the second filter layer 1022d, the third filter layer 1023d, and the light transmitting layer 1024d to the total area of the first light-shielding layer 103, the second light-shielding layer 104, the third light-shielding layer 105, and the fourth light-shielding layer 106 ranges from 1.100 to 3.300. For example, the ratio may be 1.200, 1.300, 1.400, 1.600, 1.800, 2.000, 2.400, 2.700, 2.900, 3.100, 3.200, or 3.300, which is not limited by the embodiments of the present disclosure.

For example, in one example, on a plane parallel to the main surface of the first base substrate 101, the ratio of the area of the first filter layer 1021d to the area of the first light-shielding layer 103 ranges from 2.000 to 3.000, for example, the ratio is 2.000, 2.200, 2.400, 2.600, 2.800, or 3.000.

For example, in one example, on a plane parallel to the main surface of the first base substrate 101, the ratio of the area of the second filter layer 1022d to the area of the second light-shielding layer 104 ranges from 1.1074 to 1.6938. For example, the ratio of the area of the second filter layer 1022d to the area of the second light-shielding layer 104 is 1.1074, 1.200, 1.300, 1.400, 1.500 or 1.600, which is not limited by the embodiments of the present disclosure.

For example, in one example, on a plane parallel to the main surface of the first base substrate 101, the ratio of the area of the third filter layer 1023d to the area of the third light-shielding layer 105 ranges from 1.4650 to 2.02268. For example, the ratio of the area of the third filter layer 1023d to the area of the third light-shielding layer 105 is 1.510, 1.600, 1.700, 1.800, 1.900, or 2.100, which is not limited by the embodiments of the present disclosure.

For example, in one example, on a plane parallel to the main surface of the first base substrate 101, the ratio of the area of the light transmitting layer 1024d to the area of the fourth light-shielding layer 106 ranges from 2.1760 to 3.2850. For example, the ratio of the area of the light transmitting layer 1024d to the area of the fourth light-shielding layer 106 is 2.210, 2.600, 2.700, 2.800, 2.900, or 3.100, which is not limited by the embodiments of the present disclosure.

For example, in combination with Fig. 1 to Fig. 3, the display substrate 100 further includes a data line 107 and a first sensing line 108 that extend along the first direction X, and a second sensing line 109 that extends along the second direction Y. The data line 107 intersects with the second sensing line 109 to define a plurality of pixel regions, and each pixel region includes one sub-pixel 102. A first power voltage line 110 parallel to the data line 107 is provided between adjacent sub-pixels 102, and a second power voltage line 111 parallel to the second direction Y is provided on a side of the first effective light-emitting region 1021b close to the first light-shielding layer 103. The second power voltage line 111 intersects with the first power voltage line 110 and is connected to the first drain electrode of the first driving transistor in the first pixel circuit 1021a, the orthographic projection of the second power voltage line 111 on the first base substrate 101 overlaps with the orthographic projection of the first light-shielding layer 103 on the first base substrate 101.

For example, as shown in Fig. 2, in one example, the orthographic projection of the second power voltage line 111 on the first base substrate 101 and the orthographic projection of the first light-shielding layer 103 on the first base substrate 101 have an overlapping portion. The orthographic projection of the second power voltage line 111 on the first base substrate 101 does not have an overlapping portion with all of the orthographic projection of the second light-shielding layer 104 on the first base substrate 101, the orthographic projection of the third light-shielding layer 105 on the first base substrate 101, and the orthographic projection of the fourth light-shielding layer 106 on the first base substrate 101, however, the orthographic projection of the second power voltage line 111 on the first base substrate 101 and the orthographic projection of the fourth light-shielding layer 106 on the first base substrate 101 have adjacent portions. This design can enhance the stability of the first light-shielding layer 103, and a capacitor can be formed between the first light-shielding layer 103 and the second power voltage line 111, thereby avoiding drift of the first light-shielding layer 103 when the gate signal is not turned on.

For example, as shown in Fig. 1, in another example, the orthographic projection of the second power voltage line 111 on the first base substrate 101 and the orthographic projection of the first light-shielding layer 103 on the first base substrate 101 have an overlapping portion, and the orthographic projection of the second power voltage line 111 on the first base substrate 101 does not have an overlapping portion with the orthographic projection of the second light-shielding layer 104 on the first base substrate 101, and the orthographic projection of the third light-shielding layer 105 on the first base substrate 101.

For example, in another example, the orthographic projection of the second power voltage line 111 on the first base substrate 101 does not have an overlapping portion with all of and the orthographic projection of the first light-shielding layer 103 on the first base substrate 101, the orthographic projection of the second light-shielding layer 104 on the first base substrate 101, the orthographic projection of the third light-shielding layer 105 on the first base substrate 101, and the orthographic projection of the fourth light-shielding layer 106 on the first base substrate 101.

For example, the second sensing line 109 extending along the second direction Y may extend in a curve line, a broken line, or a straight line, as long as the overall extension direction of the second sensing line 109 is along the second direction Y. In the structures shown in Fig. 1 to Fig. 3, the second sensing line 109 extends along a straight line.

For example, as shown in Fig. 3, the second power voltage line 111 is connected to the source electrode S11 of the driving transistor T11 in the first sub-pixel 1021, the second power voltage line 111 is connected to the source electrode S12 of the driving transistor T12 in the second sub-pixel 1022, the second power voltage line 111 is connected to the source electrode S13 of the driving transistor T13 in the third sub-pixel 1023, and the second power voltage line 111 is connected to the source electrode S14 of the driving transistor T14 in the fourth sub-pixel 1024.

For example, as shown in Fig. 3, the orthographic projection of the second power voltage line 111 on the first base substrate 101 overlaps with the orthographic projection of the first light-shielding layer 103 on the first base substrate 101, and overlaps with the orthographic projection of the fourth light-shielding layer 106 on the first base substrate 101, the orthographic projection of the second power voltage line 111 on the first base substrate 101 does not have an overlapping portion with the orthographic projection of the second light-shielding layer 104 on the first base substrate 101, and the orthographic projection of the third light-shielding layer 105 on the first base substrate 101. This design can enhance the stability of the first light-shielding layer 103 and the fourth light-shielding layer 106, capacitors can be formed between the first light-shielding layer 103 and the second power supply voltage line 111, as well as between the fourth light-shielding layer 106 and the second power voltage line 111, thereby avoiding drift of the first light-shielding layer 103 and the fourth light-shielding layer 106 when the gate signal is not turned on.

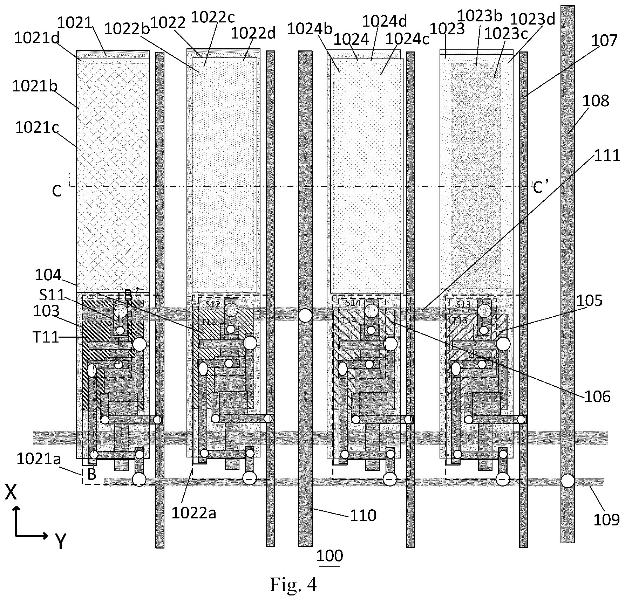

Fig. 4 is a planar structural schematic diagram of further another display substrate provided by at least one embodiment of the present disclosure, as shown in Fig. 4, the orthographic projection of the second power voltage line 111 on the first base substrate 101 has an overlapping portion with all of the orthographic projection of the first light-shielding layer 103 on the first base substrate 101, the orthographic projection of the second light-shielding layer 104 on the first base substrate 101, the orthographic projection of the third light-shielding layer 105 on the first base substrate 101, and the orthographic projection of the fourth light-shielding layer 106 on the first base substrate 101.

For example, as shown in Fig. 4, the overlapping area of the orthographic projection of the second power voltage line 111 on the first base substrate 101 and the orthographic projection of the first light-shielding layer 103 on the first base substrate 101 is greater than the overlapping area of the orthographic projection of the second power voltage line 111 on the first base substrate 101 and the orthographic projection of the second light-shielding layer 104 on the first base substrate 101, and the capacitance value between the first light-shielding layer 103 and the second power voltage line 111, and the capacitance value between the fourth light-shielding layer 106 and the second power voltage line 111 are balanced.

For example, as shown in Fig. 4, the overlapping area of the orthographic projection of the second power voltage line 111 on the first base substrate 101 and the orthographic projection of the first light-shielding layer 103 on the first base substrate 101 is greater than the overlapping area of the orthographic projection of the second power voltage line 111 on the first base substrate 101 and the orthographic projection of the third light-shielding layer 105 on the first base substrate 101. This design can enhance the stability of the first light-shielding layer 103 and the third light-shielding layer 105, and balance the capacitance value between the first light-shielding layer 103 and the second power voltage line 111, and the capacitance value between the third light-shielding layer 105 and the second power voltage line 111.

For example, as shown in Fig. 4, the overlapping area of the orthographic projection of the second power voltage line 111 on the first base substrate 101 and the orthographic projection of the first light-shielding layer 103 on the first base substrate 101 is greater than the overlapping area of the orthographic projection of the second power voltage line 111 on the first base substrate 101 and the orthographic projection of the fourth light-shielding layer 106 on the first base substrate 101. The overlapping area of the orthographic projection of the second power voltage line 111 on the first base substrate 101 and the orthographic projection of the fourth light-shielding layer 106 on the first base substrate 101 is greater than the overlapping area of the orthographic projection of the second power voltage line 111 on the first base substrate 101 and the orthographic projection of the third light-shielding layer 105 on the first base substrate 101. The overlapping area of the orthographic projection of the second power voltage line 111 on the first base substrate 101 and the orthographic projection of the third light-shielding layer 105 on the first base substrate 101 is greater than the overlapping area of the orthographic projection of the second power voltage line 111 on the first base substrate 101 and the orthographic projection of the second light-shielding layer 104 on the first base substrate 101. This design can enhance the stability of the first light-shielding layer 103, the second light-shielding layer 104, the third light-shielding layer 105, and the fourth light-shielding layer 106, and balance the capacitance value between the first light-shielding layer 103 and the second power voltage line 111, the capacitance value between the second light-shielding layer 104 and the second power voltage line 111, the capacitance value between the third light-shielding layer 106 and the second power voltage line 111, and the capacitance value between the fourth light-shielding layer 106 and the second power voltage line 111.

For example, in one example, in one first sub-pixel 1021, the overlapping area of the orthographic projection of the second power voltage line 111 on the first base substrate 101 and the orthographic projection of the first light-shielding layer 103 on the first base substrate 101 ranges from 0.03 square micrometers to 0.30 square micrometers. In one second sub-pixel 1022, the overlapping area of the orthographic projection of the second power voltage line 111 on the first base substrate 101 and the orthographic projection of the fourth light-shielding layer 106 on the first base substrate 101 ranges from 0.02 square micrometers to 0.20 square micrometers. In one third sub-pixel 1023, the overlapping area of the orthographic projection of the second power voltage line 111 on the first base substrate 101 and the orthographic projection of the third light-shielding layer 105 on the first base substrate 101 ranges from 0 to 0.05 square micrometers, and in one fourth sub-pixel 1024, the overlapping area of the orthographic projection of the second power voltage line 111 on the first base substrate 101 and the orthographic projection of the second light-shielding layer 104 on the first base substrate 101 ranges from 0 to 0.08 square micrometers.

For example, the second power voltage line 111 extending along the second direction Y may extend in a curve line, a broken line, or a straight line, as long as the overall extension direction of the second power voltage line 111 is along the second direction Y. In the structures shown in Fig. 1 to Fig. 4, the second power voltage line 111 extends along a straight line.

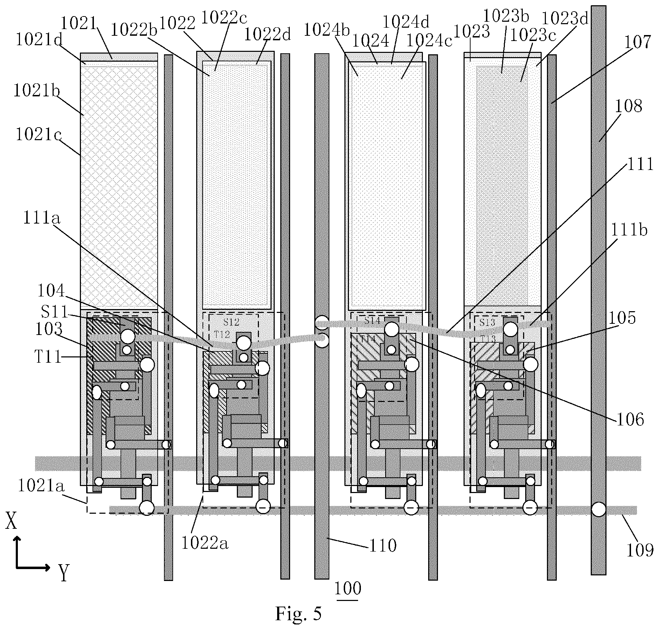

Fig. 5 is a planar structural schematic diagram of further another display substrate provided by at least one embodiment of the present disclosure, as shown in Fig. 5, the second power voltage line 111 includes a first portion 111a and a second portion 111b that are spaced apart from each other. The first portion 111a and the second portion 111b are connected to the first power voltage line 110 through different via structures. For example, setting the second power voltage line 111 to include a plurality of portions that are spaced apart from each other and not directly connected with each other can avoid the accumulation of too much charges on the second power voltage line 111 due to the second power voltage line 111 being too long.

For example, in the structure shown in Fig. 5, both the first portion 111a and the second portion 111b extend along a curve line, but the embodiments of the present disclosure are not limited to this, both the first portion 111a and the second portion may also 111b extend along a straight line.

For example, as shown in Fig. 5, the first portion 111a is connected to the first source electrode S11 of the first driving transistor T11 in the first pixel circuit 1021a, and the second source electrode S12 of the second driving transistor T12 in the second pixel circuit 1022a. The second portion 111b is connected to the third source electrode S13 of the third driving transistor T13 in the third pixel circuit 1023a, and the fourth source electrode S14 of the fourth driving transistor T14 in the fourth pixel circuit 1024a, thereby balancing the accumulated charges on the first portion 111a and the second portion 111b, and making the charges more dispersed.

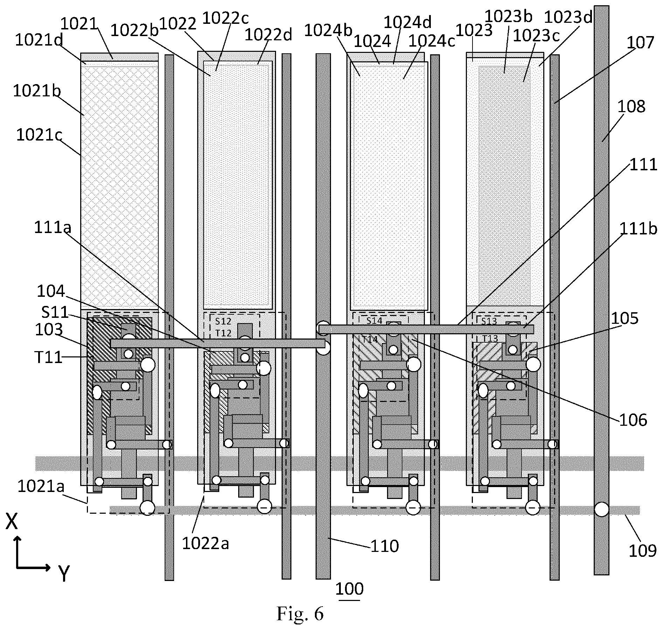

Fig. 6 is a planar structural schematic diagram of further another display substrate provided by at least one embodiment of the present disclosure, as shown in Fig. 6, the extension direction of the first portion 111a is parallel to the extension direction of the second portion 111b. Both the first portion 111a and the second portion 11 1b extend along a straight line. The first portion 11 1a is connected to the first source electrode S11 of the first driving transistor T11 in the pixel circuit 1021a and the second source electrode S12 of the second driving transistor T12 in the second pixel circuit 1022a, the second portion 111b is connected to the third source electrode S13 of the third driving transistor T13 in the third pixel circuit 1023a and the fourth source electrode S14 of the fourth driving transistor T14 in the fourth pixel circuit 1024a, and the first portion 111a is located on the side of the second portion 111b close to the second sensing line 109, thereby making the wiring process easier.

For example, as shown in Fig. 6, the first portion 11 1a is connected to the middle region of the first source electrode S11 and the second source electrode S12, while the second portion 111b is connected to the edge of the third source electrode S13 away from the second sensing line 109 and the edge of the fourth source electrode S14 away from the second sensing line 109, which can make the display substrate more finely designed in size.

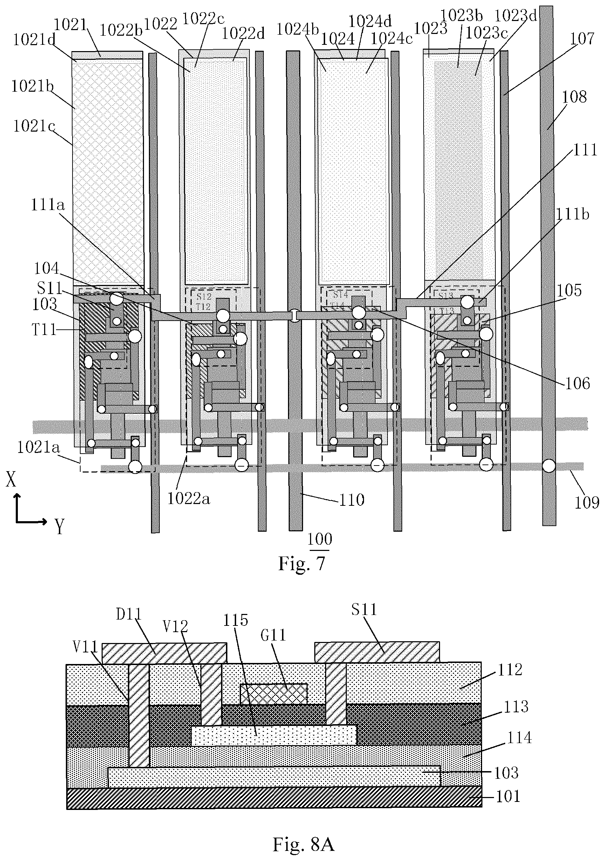

Fig. 7 is a planar structural schematic diagram of further another display substrate provided by at least one embodiment of the present disclosure, as shown in Fig. 7, both the first portion 111a and the second portion 111b extend along a broken line. The first portion 111a is connected to the edge of the first source electrode S11 away from the second sensing line 109 and the middle region of the third source electrode S13, the second portion 111b is connected to the edge of the second source electrode S12 away from the second sensing line 109 and the middle region of the fourth source electrode S14. The first portion 111a and the second portion 111b are electrically connected to the first power voltage line 110 through the same via structure. The first portion 111a and the second portion 111b both extend along a broken line, and therefore the connection positions of the second power voltage line 111 and the first source electrode S11, the second source electrode S12, the third source electrode S13, and the fourth source electrode S14 can be flexibly adjusted according to the circuit design situation.

For example, Fig. 8A is a cross-sectional structural schematic diagram of the display substrate in Fig. 1 to Fig. 3 along a line A-A', as shown in Fig. 8A, the first drain electrode D11 and the first light-shielding layer 103 are connected through a first via V11, the first via V11 sequentially penetrates the interlayer insulation layer 112, the gate insulation layer 113, and the buffer layer 114. As shown in Fig. 8A, the first drain electrode D11 and the active layer 115 are connected through a second via V12, and the first source electrode S11 and the active layer 115 are connected through a second via V12, the second via V12 sequentially penetrates the interlayer insulation layer 112 and the gate insulation layer 113. In the structure shown in Fig. 8A, the gate electrode G11 is on the side of the active layer 115 away from the first base substrate 101. Of course, the embodiments of the present disclosure are not limited to this, the gate electrode G11 may also be provided on the side of the active layer 115 close to the first base substrate 101.

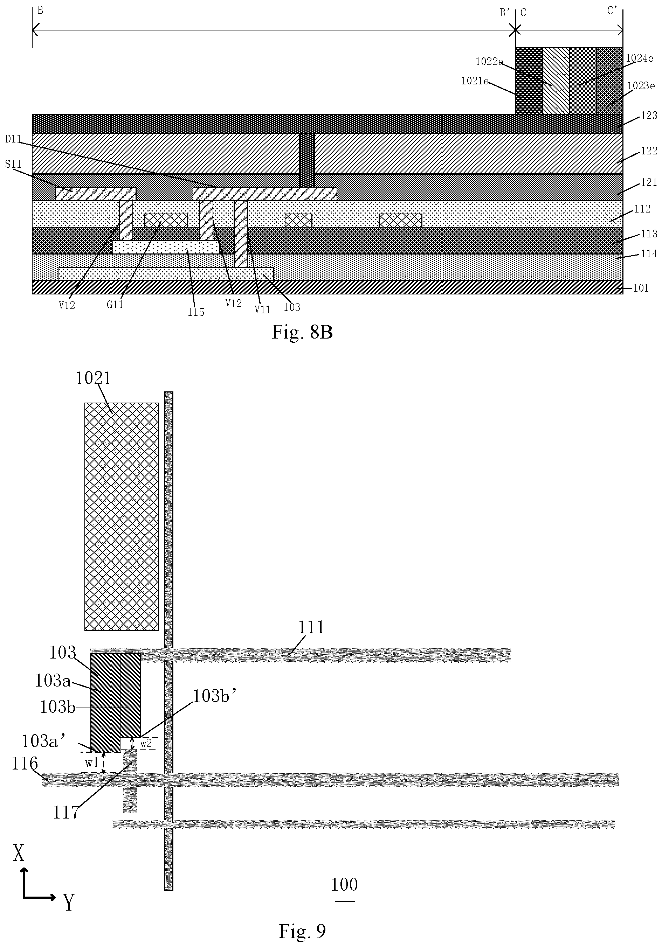

Fig. 8B is a cross-sectional structural schematic diagram of the display substrate in Fig. 4 along a line B-B' and a line C-C', as shown in Fig. 8B, a passivation layer 121 and a planarization layer 122 are provided on the side of the first drain electrode D11 and the first source electrode S11 away from the first base substrate 101, and a first electrode 123 is provided on the side of the planarization layer 122 away from the first base substrate 101. The first electrode 123 may be an anode, and is connected to the first drain electrode D11. On the side of the first electrode 123 away from the first base substrate 101, a first color light-emitting unit 1021e, a second color light-emitting unit 1022e, a third color light-emitting unit 1023e, and a fourth color light-emitting unit 1024e are arranged side by side.

For example, in one example, the first color light-emitting unit 1021e, the second color light-emitting unit 1022e, the third color light-emitting unit 1023e, and the fourth color light-emitting unit 1024e may respectively be the red light-emitting unit, the green light-emitting unit, the blue light-emitting unit, and the white light-emitting unit. The first color light-emitting unit 1021e, the second color light-emitting unit 1022e, and the third color light-emitting unit 1023e may respectively be the first color light-emitting layer emitting the first color light, the second color light-emitting layer emitting the second color light, and the third color light-emitting layer emitting the third color light.

For example, in another example, the first color light-emitting unit 1021e, the second color light-emitting unit 1022e, the third color light-emitting unit 1023e, and the fourth color light-emitting unit 1024e may be a combination of a white light-emitting element and a first filter layer, a second filter layer, a third filter layer, and a light transmitting layer. The first filter layer, the second filter layer, and the third filter layer may respectively be a red filter layer, a green filter layer, and a blue filter layer.

For example, a second electrode is further provided on the side of the first color light-emitting unit 1021e, the second color light-emitting unit 1022e, the third color light-emitting unit 1023e, and the fourth color light-emitting unit 1024e away from the first base substrate 101, the second electrode may be a cathode. The other structures of the display substrate 100 can refer to conventional designs, and the embodiments of the present disclosure are not limited to this.

It should be noted that the thin film transistor in the embodiments of the present disclosure may be a bottom gate thin film transistor or a top gate thin film transistor. Fig. 8A and Fig. 8B are illustrated using the top gate thin film transistor as an example.

Fig. 9 is a planar structural schematic diagram of further another display substrate provided by at least one embodiment of the present disclosure, as shown in Fig. 9, the display substrate 100 further includes a first gate line 116 extending along the second direction Y, and a first gate electrode 117 extending from the first gate line 116 towards the side close to the second power voltage line 111. The planar shape of the first light-shielding layer 103 includes a first sub-portion 103a and a second sub-portion 103b extending along the first direction X. There is a gap region between the first light-shielding layer 103 and the first gate line 116 and a gap region between the first light-shielding layer 103 and the first gate electrode 117, so that a first capacitor is formed between the first light-shielding layer 103 and the first gate line 116, and a second capacitor is formed between the first light-shielding layer 103 and the first gate electrode 117. The first distance W1 between the first side 103a' of the first sub-portion 103a close to the first gate line 116 and the first gate line 116 is greater than the second distance W2 between the second side 103b' of the second sub-portion 103b close to the first gate electrode 117 and the first gate electrode 117. Because of the fact that the area of the first sub-portion 103a is greater than the area of the second sub-portion 103b on the plane parallel to the main surface of the first base substrate 101, by setting the first distance W1 between the first side 103a' of the first sub-portion 103a close to the first gate line 116 and the first gate line 116 to be greater than the second distance W2 between the second side 103b' of the second sub-portion 103b close to the first gate electrode 117 and the first gate electrode 117, it can be ensured that the first capacitance between the first light-shielding layer 103 and the first gate line 116 is equal or roughly equal to the second capacitance between the first light-shielding layer 103 and the first gate electrode 117.

For example, as shown in Fig. 9, on the plane parallel to the main surface of the first base substrate 101, the overall shape formed by the first sub-portion 103a and the second sub-portion 103b included in the first light-shielding layer 103 includes a step shape, and the step shape is located at the edge of the first light-shielding layer 103 close to the first gate line 116.

For example, the first sub-portion 103a and the second sub-portion 103b included in the first light-shielding layer 103 may be a whole or connected through a bridging structure, the embodiments of the present disclosure are not limited to this.

It should be noted that, although Fig. 9 shows the design in the first sub-pixel 1021, the above structural design can also apply in the second sub-pixel, the third sub-pixel, and the fourth sub-pixel, that is, the second light-shielding layer 104, the third light-shielding layer 105, and the fourth light-shielding layer 106 all have the structure that includes two portions similar to the first light-shielding layer 103.

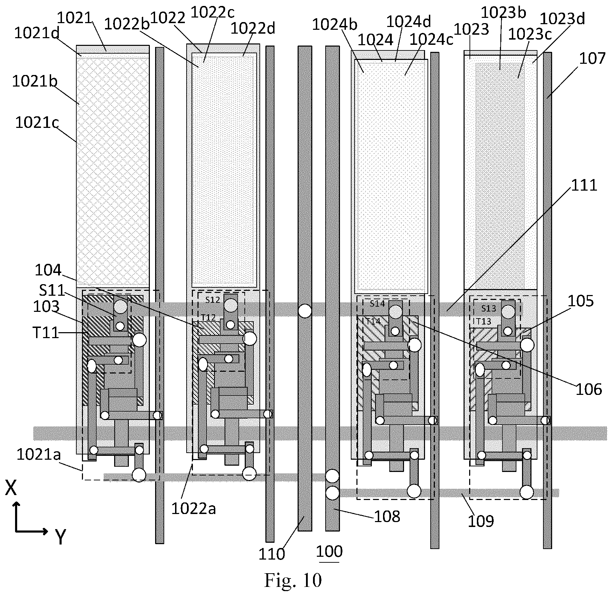

Fig. 10 is a planar structural schematic diagram of further another display substrate provided by at least one embodiment of the present disclosure, as shown in Fig. 10, the second sensing line 109 includes two portions that are spaced apart from each other, which are connected to the first sensing line 108 through different via structures. The first sensing line 108 is adjacent to the first power voltage line 110. The first sensing line 108 and the first power voltage line 110 are both provided between the second sub-pixel 1022 and the fourth sub-pixel 1024. For example, setting the second sensing line 109 to include two portions that are spaced apart from each other and not directly connected with each other can avoid the accumulation of too much charges on the second sensing line 109 due to the second sensing line 109 being too long. The other structural designs on the display substrate 100 can be referred to in the relevant description above, and will not be repeated here.

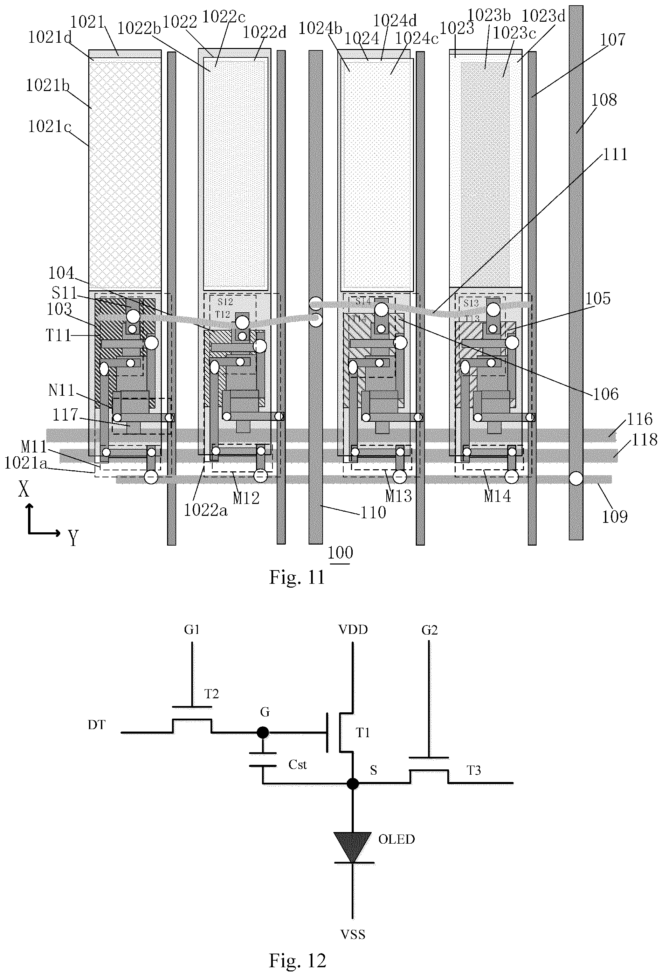

Fig. 11 is a planar structural schematic diagram of further another display substrate provided by at least one embodiment of the present disclosure, as shown in Fig. 11, the display substrate 100 further includes a second gate line 118 parallel to the first gate line 116, the first gate line 117 is configured as the gate electrode of the first switching transistor N11, the second gate line 118 is configured as the gate electrode of the first sensing transistor M11 included in the first pixel circuit 1021a, the gate electrode of the second sensing transistor M12 included in the second pixel circuit 1022a, the gate electrode of the third sensing transistor M13 included in the third pixel circuit 1023a, and the gate electrode of the fourth sensing transistor M14 included in the fourth pixel circuit 1024a, the display substrate 100 includes both the first gate line 116 and the second gate line 118, such that in one sub-pixel, the switching transistor (e.g., the first switching transistor) and the corresponding sensing transistor (e.g., the first sensing transistor) are controlled by different control lines, which further makes the adjustment of the switching transistors and sensing transistors in the same sub-pixel more flexible.

For example, the display substrates in Fig. 1 to Fig. 11 above are all organic light-emitting diode (OLED) display substrates, and the first light-emitting element, the second light-emitting element, the third light-emitting element, and the fourth light-emitting element are all OLEDs. The above display substrate includes a plurality of gate lines and a plurality of data lines for providing scanning signals (control signals) and data signals to drive the plurality of sub-pixels. The pixel circuit includes a drive sub-circuit for driving the light-emitting element to emit light and a detection sub-circuit for detecting the electrical characteristics of the sub-pixel to achieve external compensation. The specific structure of the pixel circuit is not limited by the embodiments of the present disclosure.

Fig. 12 is a schematic diagram of a 3T1C pixel circuit for a display substrate provided by at least one embodiment of the present disclosure, as needed, the pixel circuit may further include a compensation circuit and a reset circuit, etc. The embodiments of the present disclosure are not limited to this.

For example, as shown in Fig. 12, the pixel circuit includes a first transistor T1, a second transistor T2, a third transistor T3, and a storage capacitor Cst. For example, the first transistor T1 may be a driving transistor, the second transistor T2 may be a switching transistor, the third transistor T3 may be a sensing transistor, the first electrode of the second transistor T2 is electrically connected to the first capacitor electrode of the storage capacitor Cst and the gate electrode of the first transistor T1, and the second electrode of the second transistor T2 is configured to receive the data signal GT, the second transistor T2 is configured to write the data signal DT into the gate electrode of the first transistor T1 and the storage capacitor Cst in response to the first control signal G1. The first electrode of the first transistor T1 is electrically connected to the second capacitor electrode of the storage capacitor Cst, and is configured to be electrically connected to the first electrode of the light-emitting element. The second electrode of the first transistor T1 is configured to receive a first power voltage V1 (such as a high power voltage VDD), and the first transistor T1 is configured to control the current used to drive the light-emitting element under the control of the gate voltage of the first transistor T1; the first electrode of the third transistor T3 is electrically connected to the first electrode of the first transistor T1 and the second capacitor electrode of the storage capacitor Cst, the second electrode of the third transistor T3 is configured to be connected to the first detection line to be connected to the external detection circuit, and the third transistor T3 is configured to detect the electrical characteristics of the sub-pixel to which it belongs in response to the second control signal G2 to achieve external compensation; the electrical characteristics include, for example, the threshold voltage and/or carrier mobility of the first transistor T1, or the threshold voltage and driving current of the light-emitting element. The external detection circuit, for example, is a conventional circuit that includes a digital to analog converter (DAC) and an analog-to-digital converter (ADC), which is omitted in the embodiments of the present disclosure.

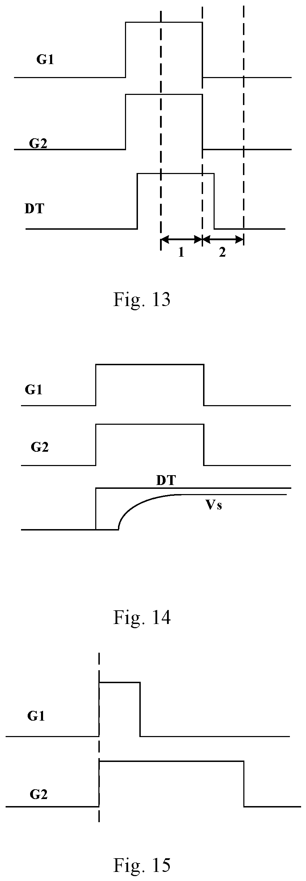

For example, the transistors used in the embodiments of the present disclosure may all be thin film transistors, field-effect transistors, or other switching devices with the same characteristics. In the embodiments of the present disclosure, the above transistors being thin film transistors are used as examples to illustrate. The source electrode and the drain electrode of the transistor used here may be symmetrical in structure, so the source electrode and the drain electrode can be structurally indistinguishable. In addition, according to the characteristics of the transistors, the transistors can be divided into N-type transistors and P-type transistors. When the transistor is a P-type transistor, the turn-on voltage is a low-level voltage (such as 0V, -5V, -10V or other suitable voltage), and the turn-off voltage is a high-level voltage (such as 5V, 10V or other suitable voltage); when the transistor is an N-type transistor, the turn-on voltage is a high-level voltage (e.g. 5V, 10V or other suitable voltage), and the turn-off voltage is a low-level voltage (e.g. 0V, -5V, -10V or other suitable voltage). It should be noted that in the following description, the transistors in Fig. 13 being the N-type transistors is used as an example to illustrate, but the embodiments of the present disclosure are not limited to this, and the transistors may also be other types of transistors.

The working principle of the pixel circuit shown in Fig. 12 is illustrated by combining the signal timing diagrams shown in Fig. 13 to Fig. 15, in which Fig. 13 is a signal timing diagram of the pixel circuit in Fig. 12 during a display process, Fig. 14 is a first signal timing diagram of the pixel circuit in Fig. 12 during a detection process, and Fig. 15 is a second signal timing diagram of the pixel circuit in Fig. 12 during a detection process.

For example, as shown in Fig. 13, the display process of each frame of the image includes a data writing and resetting stage 1 and a light-emitting stage 2. Fig. 13 shows the timing waveform of each signal in each stage. One operating process of the 3T1C pixel circuit includes: in the data writing and resetting stage 1, the first control signal G1 and the second control signal G2 are both turn-on signals, the second transistor T2 and the third transistor T3 are turned on, and the data signal DT is transmitted to the gate electrode of the first transistor T1 through the second transistor T2, the analog-to-digital converter writes a reset signal to the first electrode of the light-emitting element (such as the anode of an OLED) through the third transistor T3. The first transistor T1 is turned on and generates a driving current to charge the first electrode of the light-emitting element to the working voltage; in the light-emitting stage 2, the first control signal G1 and the second control signal G2 are both turn-off signals. Due to the bootstrap effect of the storage capacitor Cst, the voltages at both ends of the storage capacitor Cst remain unchanged, the first transistor T1 operates in a saturated state with constant current and drives the light-emitting element to emit light.

For example, Fig. 14 shows the signal timing diagram of the pixel circuit when detecting the threshold voltage. One operating process of the 3T1C pixel circuit includes: the first control signal G1 and the second control signal G2 are both turn-on signals, the second transistor T2 and the third transistor T3 are turned on, and the data signal DT is transmitted to the gate electrode of the first transistor T1 through the second transistor T2; the analog-to-digital converter writes a reset signal to the first electrode (node S) of the light-emitting element through the detection line connected to the third transistor T3 and the third transistor T3. The first transistor T1 is turned on and charges the node S until the first transistor T1 is turned off. Then, the threshold voltage of the first transistor T1 can be obtained by sampling the voltage on the detection line through the analog-to-digital converter, this process can be carried out, for example, when the display device formed by the display substrate is in a shutdown state.

For example, Fig. 15 shows the signal timing diagram of the pixel circuit when detecting threshold voltage. One operating process of the 3T1C pixel circuit includes: in the first stage, the first control signal G1 and the second control signal G2 are both turn-on signals, the second transistor T2 and the third transistor T3 are turned on, and the data signal DT is transmitted to the gate electrode of the first transistor T1 through the second transistor T2; the analog-to-digital converter writes a reset signal to the first electrode (node S) of the light-emitting element through the detection line connected to the third transistor T3 and the third transistor T3; in the second stage, the first control signal G1 is the turn-off signal, the second control signal G1 is the turn-on signal, the second transistor T2 is turned off, the third transistor T3 is turned on, and the detection line connected to the third transistor T3 is floating. Due to the bootstrap effect of the storage capacitor Cst, the voltages at both ends of the storage capacitor Cst remain unchanged, the first transistor T1 works in a saturated state with constant current and drives the light-emitting element to emit light, then, the analog-to-digital converter samples the voltage on the detection line and combines it with the magnitude of the light-emitting current to calculate the carrier mobility in the first transistor T1. For example, this process can be carried out during the hidden stage between display stages.

Through the above detection, the electrical characteristics of the first transistor T1 can be obtained and the corresponding compensation algorithm can be implemented.

It can be understood that the first control signal G1 and the second control signal G2 may not be turn-on signals at the same time. For example, one operating process of the 3T1C pixel circuit includes: in the first stage, the first control signal G1 is the turn-on signal before the second control signal G2.

For example, the display substrate 100 may further include a data driving circuit and a scanning driving circuit. The data driving circuit is configured to output data signals as needed (such as input image signals from a display device including a display substrate), such as the above data signal DT. The pixel circuit of each sub-pixel is further configured to receive the data signal and apply the data signal to the gate electrode of the first transistor. The scanning driving circuit is configured to output various scanning signals, such as the first control signal G1 and the second control signal G2, the scanning driving circuit may be an integrated circuit chip (IC) or a gate drive circuit (GOA) directly prepared on display substrates.

For example, the display substrate 100 further includes a control circuit. For example, the control circuit is configured to control the data driving circuit to apply data signals, and to control the gate driving circuit to apply scanning signals. An example of the control circuit is a timing control circuit (T-con). The control circuit may be various forms, such as including a processor and a memory. The memory includes executable codes, and the processor runs the executable codes to execute the above detection method.

For example, the processor may be a central processing unit (CPU) or other form of processing device with data processing and/or instruction execution capabilities, such as a microprocessor, a programmable logic controller (PLC), etc.

For example, the storage device may include one or more computer program products, which may include various forms of computer-readable storage media, such as volatile memory and/or non-volatile memory. The volatile memory may include, for example, random access memory (RAM) and/or cache memory. The non-volatile memory may include, for example, read-only memory (ROM), hard drives, flash memory, etc. One or more computer program instructions can be stored on the computer-readable storage medium, and the processor can perform the expected function of the program instructions. In the computer-readable storage media, various applications and data can also be stored, such as electrical characteristic parameters obtained in the above detection methods.

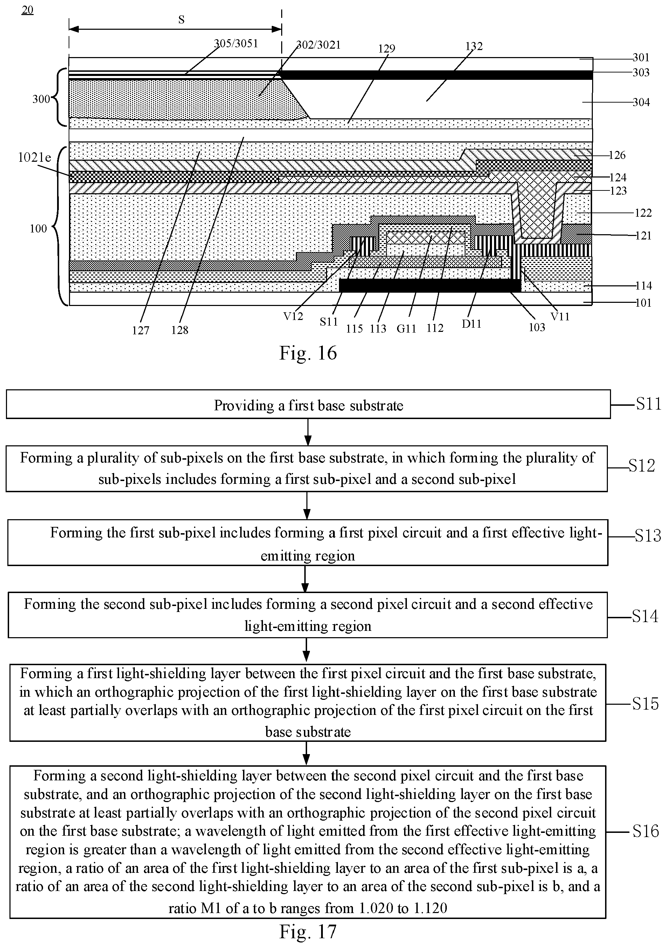

For example, Fig. 16 is a cross-sectional structural schematic diagram of a display device provided by at least one embodiment of the present disclosure, as shown in Fig. 16, the display device 20 includes the display substrate 100 in any one of the above embodiments and a cover plate 300 opposite to the display substrate 100. The cover plate 300 includes a second base substrate 301, and a quantum dot layer 302 is provided on a side of the second base substrate 301 close to the display substrate 100. The quantum dot layer 302 includes a plurality of quantum dot units 3021, which correspond to the plurality of sub-pixels in one-to-one correspondence, the color of each of the plurality of quantum dot units 3021 is the same as the color of the corresponding sub-pixel, the plurality of quantum dot units 3021 can increase the color gamut of the display device 20.

For example, in one example, the plurality of quantum dot units 3021 include a first quantum dot unit, a second quantum dot unit, and a third quantum dot unit. The color of the first quantum dot unit is the same as the color of the first sub-pixel, the color of the second quantum dot unit is the same as the color of the second sub-pixel, and the color of the third quantum dot unit is the same as the color of the third sub-pixel.

For example, in one example, the first sub-pixel, the second sub-pixel, and the third sub-pixel are respectively the red sub-pixel, the green sub-pixel, and the blue sub-pixel. Correspondingly, the first quantum dot unit, the second quantum dot unit, and the third quantum dot unit are respectively the red quantum dot unit, the green quantum dot unit, and the blue quantum dot unit.

For example, in one example, the plurality of quantum dot units 3021 include a first quantum dot unit, a second quantum dot unit, a third quantum dot unit, and a fourth quantum dot unit. The color of the first quantum dot unit is the same as the color of the first sub-pixel, the color of the second quantum dot unit is the same as the color of the second sub-pixel, and the color of the third quantum dot unit is the same as the color of the third sub-pixel, and the color of the fourth quantum dot unit is the same as the color of the fourth sub-pixel.

For example, in one example, the first sub-pixel, the second sub-pixel, the third sub-pixel, and the fourth sub-pixel are respectively the red sub-pixel, the green sub-pixel, the blue sub-pixel, and the white sub-pixel. Correspondingly, the first quantum dot unit, the second quantum dot unit, the third quantum dot unit, and the fourth quantum dot unit are respectively the red quantum dot unit, the green quantum dot unit, the blue quantum dot unit, and the white quantum dot unit.

For example, Fig. 16 illustrates the correspondence between the first sub-pixel and the first quantum dot unit. A passivation layer 121 and a planarization layer 122 are provided on the side of the first drain electrode D11 and the first source electrode S11 away from the first base substrate 101, and a first electrode 123 is provided on the side of the planarization layer 122 away from the first base substrate 101. The first electrode 123 may be an anode, and is connected to the first drain electrode D11. A pixel definition layer 124 is provided on the side of the first electrode 123 away from the first base substrate 101, and a first color light-emitting unit 1021e is provided on the side of the pixel definition layer 124 away from the first base substrate 101. In one example, the first color light-emitting unit 1021e is the first color light-emitting layer, and a second electrode 126 is provided on the side of the first color light-emitting unit 1021e away from the first base substrate 101, the second electrode 126 may be a cathode.

For example, in another example, the first color light-emitting unit 1021e, the second color light-emitting unit 1022e, and the third color light-emitting unit 1023e may be a combination of a white light-emitting element and a first filter layer, a second filter layer, and a third filter layer. The first filter layer, the second filter layer, and the third filter layer may be a red filter layer, a green filter layer, and a blue filter layer, respectively. The embodiments of the present disclosure are not limited herein.

For example, in another example, the first color light-emitting unit 1021e, the second color light-emitting unit 1022e, the third color light-emitting unit 1023e, and the fourth color light-emitting unit 1024e may be a combination of a white light-emitting element and a first filter layer, a second filter layer, a third filter layer, and a light transmitting layer. The first filter layer, the second filter layer, and the third filter layer may be a red filter layer, a green filter layer, and a blue filter layer, respectively. The embodiments of the present disclosure are not limited herein.

For example, as shown in Fig. 16, the first drain electrode D11 and the first light-shielding layer 103 are connected through a first via V11, which sequentially penetrates the interlayer insulation layer 112 and the buffer layer 114. The first drain electrode D11 and the active layer 115 are connected through a second via V12, and the first source electrode S11 and the active layer 115 are connected through the second via V12, the second via V12 penetrates the interlayer insulation layer 112. For example, the gate electrode G11 is provided on the side of the active layer 115 away from the first base substrate 101.

It should be noted that the thin film transistors in the embodiments of the present disclosure may be bottom gate type thin film transistors or top gate type thin film transistors. The accompanying drawings of the embodiments of the present disclosure illustrate the thin film transistors being the top gate type thin film transistors as an example.

For example, the pixel definition layer 124 includes a plurality of openings, and each of the openings of the pixel definition layer 124 corresponds to the opening region of each sub-pixel of the display device 20 in one-to-one correspondence.

For example, the first color light-emitting unit 1021e covers the pixel definition layer 124 and the plurality of openings of the pixel definition layer 124. As shown in Fig. 16, the portion of the first color light-emitting unit 1021e located in the plurality of openings of the pixel definition layer 124 is in contact with the first electrode 123 (anode), while the portion of the first color light-emitting unit 1021e covering the pixel definition layer 124 is not in contact with the first electrode 123 (anode). In this way, when the first color light-emitting unit 1021e realizes the light-emitting function, the portion of the first color light-emitting unit 1021e that is not in contact with the pixel definition layer 124 emits light, and the portion of the first color light-emitting unit 1021e covering the pixel definition layer 124 does not emit light.

For example, the first color light-emitting unit 1021e is the first color light-emitting layer. In other embodiments, the first color light-emitting unit 1021e includes one or more layers of an electron transport layer (ETL), an electron injection layer (EIL), a hole transport layer (HTL), and a hole injection layer (HIL) in addition to the first color light-emitting layer.

For example, the display substrate 100 further includes a first thin film encapsulation layer 129 and a second thin film encapsulation layer 127. The second thin film encapsulation layer 127 covers the side of the second electrode 126 (cathode) away from the first base substrate 101, and plays an encapsulation role. The first thin film encapsulation layer 129 can be used to package the quantum dot layer mentioned later. The first thin film encapsulation layer 129 is located on a side of the support layer 132 away from the second base substrate 302. After the display substrate 100 and the cover plate 300 are arranged opposite to form the display device 20, the first thin film encapsulation layer 129 and the second thin film encapsulation layer 127 are opposite each other.

For example, the second thin film encapsulation layer 127 maybe a high resistance water type film layer, which can be used to prevent external water and oxygen from affecting the display substrate 100. For example, the second thin film encapsulation layer 127 can be made of materials such as silicon nitride or silicon oxide.

For example, as shown in Fig. 16, the display device 20 further includes a filling material 128 between the cover plate 300 and the display substrate 100. The filling material 128 can fill the gap formed after the cover plate 300 and the display substrate 100 are paired to form the display device 20. The filling material 128 is specifically provided between the first film encapsulation layer 129 and the second film encapsulation layer 127. The first thin film encapsulation layer 129 and the second thin film encapsulation layer 127, as well as the filling material 128 between the first thin film encapsulation layer 129 and the second thin film encapsulation layer 127 form the encapsulation structure and play an encapsulation role in the display device 100. The filling material 128 can not only support the cover plate 300 of the display device 20, but also package the cover plate 300 of the display device 20 and the display substrate 100. When the filling material 128 is a curable transparent liquid, the display device 100 further includes a filling material barrier wall structure provided on the side of the second thin film encapsulation layer 127 of the display substrate 100 away from the first base substrate 101. The filling material barrier wall structure is ring-shaped around the periphery of the second thin film encapsulation layer 127, and the filling material 128 is filled in the area surrounded by the filling material barrier wall structure.

For example, as shown in Fig. 16, each opening of the pixel definition layer 124 of the display substrate 100 corresponds to the opening region of each sub-pixel of the display device 20 in one-to-one correspondence, and each opening region S of the cover plate 300 of the display device 20 correspond to each opening of the pixel definition layer 124 of the display substrate 100 in one-to-one correspondence. When the display device 20 realizes the display function, the light emitted from the first color light-emitting unit 1021e that does not in contact with the pixel definition layer 124 passes through the opening regions S of the cover plate 300 of the display device 20 and enters the human eyes, thereby achieving the display of the image.

For example, as shown in Fig. 16, the cover plate 300 includes the second base substrate 301, and a black matrix 303 and a support layer 304 stacked on a side of the second base substrate 301 close to the display substrate 100. Both the black matrix 303 and the support layer 304 have a plurality of openings, and the plurality of openings of the black matrix 303 at least partially overlap with, for example, most overlap with or basic overlap with, the plurality of openings of the support layer 304, respectively, to form the above plurality of opening regions S. The black matrix 303 is used to avoid the lateral light emitted by the first color light-emitting unit 1021e of the display substrate 100 from shining on adjacent sub-pixels, thereby avoiding the problem of color mixing in the display device 20. The support layer 304 has a specific height and can be used as a spacer. After the display substrate 100 and the cover plate 300 are paired, the support layer 304 can be used to support the cover plate 300 of the display device 20.

For example, in one example, the black matrix 303 may be away from the second base substrate 301 relative to the support layer 304. In another example, the black matrix 303 may also be close to the second base substrate 301 relative to the support layer 304.

For example, the embodiments of the present disclosure do not limit the material of the black matrix 303, and material selection can be based on the ability to prevent pixel light leakage. For example, the material of the black matrix 303 may be a metal material, such as chromium, aluminum, silver, or aluminum silver alloy.

For example, as shown in Fig. 16, the cover plate 300 of the display device 20 further includes a quantum dot layer 302 on the second base substrate 301, the quantum dot layer 302 includes a plurality of quantum dot units 3021, each of the quantum dot units is located within an opening region S.

For example, because each opening region S corresponds to each opening of the pixel definition layer 124 of the display substrate 100 in one-to-one correspondence, the quantum dot unit 3021 located within each opening region S also corresponds to each opening of the pixel definition layer 124 in one-to-one correspondence. The light emitted from the first color light-emitting unit 1021e of the display substrate 100, which is not in contact with the pixel definition layer 124, will pass through each quantum dot unit 3021 during the process of passing through each opening region S.

For example, the quantum dots in the quantum dot unit 3021 are spherical semiconductor nanoparticles composed of II-VI or III-V group elements, with a particle size ranging from a few nanometers to tens of nanometers. In the quantum dot materials, due to the existence of quantum confinement effects, originally continuous energy bands become discrete energy level structures, and the quantum dots can emit visible light when excited by external light. The frequency of visible light emitted varies with the particle size of the quantum dots, and the color of the light emitted can be controlled by adjusting the particle size of the quantum dots. In the embodiments of the present disclosure, each quantum dot unit 3021 can emit corresponding color light under the excitation of the light emitted by the first color light-emitting unit 1021e of the display substrate 100 to enhance the color gamut.

For example, due to the influence of quantum dot material properties, the quantum dot units may not be able to fully absorb the excitation light shining on them. By increasing the thickness of the quantum dot units, the quantum dot units can absorb as much excitation light as possible to improve the light-emitting efficiency of the quantum dot units. For example, the black matrix can also be used as a barrier structure to isolate various quantum dot units, ensuring that there is no color mixing between quantum dot units of different colors. Due to the influence of the material and manufacturing process of the black matrix, the thickness of the black matrix cannot reach $2\mu n$ and above, the thickness of each quantum dot unit cannot reach $2\mu m$ and above. Therefore, relying solely on the black matrix as a barrier structure to isolate each quantum dot unit is difficult to make the quantum dot unit very thick, thereby limiting the thickness of the quantum dot unit.

For example, each quantum dot unit 3021 is located within the opening region S formed by the black matrix 303 and the support layer 304, the black matrix 303 and the support layer 304 constitute the barrier structure of each quantum dot unit 3021. The material of the support layer 304 can be made of the material that can be made thicker, so that the barrier wall structure composed of the black matrix 303 and the support layer 304 can also be made thicker, and therefore, the thickness of each first color light-emitting unit 1021e can be made thicker, so that the first color light-emitting unit 1021e can absorb as much excitation light as possible, to improve the light-emitting efficiency of the first color light-emitting unit 1021e, thereby enhancing the light-emitting efficiency of the display device 100.

For example, as shown in Fig. 16, the display device 100 may be a top emitting display device, and the light emitted by the first color light-emitting unit 1021e of the display substrate 100 sequentially passes through the second electrode 126, the second thin film encapsulation layer 127, and the first thin film encapsulation layer 129 to illuminate the quantum dot layer 302.

For example, as shown in Fig. 16, the cover plate 300 of the display device 20 provided by the embodiments of the present disclosure further includes a color film layer 305 between the first color light-emitting unit 1021e and the second base substrate 301. The color film layer 305 includes a plurality of filter units 3051, each of the filter units 3051 is located within an opening region S. For example, the filter unit 3051 and the quantum dot unit 3021 located within one opening region S correspond to the same color. For example, in the structure shown in Fig. 16, the filter unit 3051 is a red filter unit.

For example, in one example, the filter unit 3051 may include a plurality of red filter units, a plurality of green filter units, and a plurality of blue filter units. In the case that the plurality of quantum dot units 3021 include a plurality of red quantum dot units and a plurality of green quantum dot units, the plurality of red filter units and the plurality of red quantum dot units are located within one opening region S, the plurality of green filter units and the plurality of green quantum dot units are located within one opening region S.

The embodiments of the present disclosure further provide a manufacture method of a display substrate, the manufacture method includes: providing a first base substrate; and forming a plurality of sub-pixels on the first base substrate, in which forming the plurality of sub-pixels includes forming a first sub-pixel and a second sub-pixel; forming the first sub-pixel includes forming a first pixel circuit and a first effective light-emitting region; forming the second sub-pixel includes forming a second pixel circuit and a second effective light-emitting region; forming a first light-shielding layer between the first pixel circuit and the first base substrate, and an orthographic projection of the first light-shielding layer on the first base substrate at least partially overlaps with an orthographic projection of the first pixel circuit on the first base substrate; forming a second light-shielding layer between the second pixel circuit and the first base substrate, and an orthographic projection of the second light-shielding layer on the first base substrate at least partially overlaps with an orthographic projection of the second pixel circuit on the first base substrate; a wavelength of light emitted from the first effective light-emitting region is greater than a wavelength of light emitted from the second effective light-emitting region, a ratio of an area of the first light-shielding layer to an area of the first sub-pixel is a, a ratio of an area of the second light-shielding layer to an area of the second sub-pixel is b, and a ratio M1 of a to b ranges from 1.020 to 1.120. The display substrate formed by this manufacture method can adjust the opening ratio of the plurality of sub-pixels 102 to achieve better final mixing effect, the manufacture process of the display substrate is simpler and the display substrate has higher light-emitting efficiency.

For example, Fig. 17 is a flowchart of a manufacture method of a display substrate provided by at least one embodiment of the present disclosure, as shown in Fig. 17, the manufacture method includes the following steps.

S11: providing a first base substrate;
S12: forming a plurality of sub-pixels on the first base substrate, in which forming the plurality of sub-pixels includes forming a first sub-pixel and a second sub-pixel;

S13: forming the first sub-pixel includes forming a first pixel circuit and a first effective light-emitting region;

S14: forming the second sub-pixel includes forming a second pixel circuit and a second effective light-emitting region;

S15: forming a first light-shielding layer between the first pixel circuit and the first base substrate, in which an orthographic projection of the first light-shielding layer on the first base substrate at least partially overlaps with an orthographic projection of the first pixel circuit on the first base substrate;

S16: forming a second light-shielding layer between the second pixel circuit and the first base substrate, and an orthographic projection of the second light-shielding layer on the first base substrate at least partially overlaps with an orthographic projection of the second pixel circuit on the first base substrate; a wavelength of light emitted from the first effective light-emitting region is greater than a wavelength of light emitted from the second effective light-emitting region, a ratio of an area of the first light-shielding layer to an area of the first sub-pixel is a, a ratio of an area of the second light-shielding layer to an area of the second sub-pixel is b, and a ratio M1 of a to b ranges from 1.020 to 1.120.

For example, the material of the first base substrate may include glass, plastic, or other transparent materials.

For example, the plurality of sub-pixels formed on the first base substrate may be arranged in an array, that is, the plurality of sub-pixels are arranged in both the first direction and the second direction that intersect with each other.

For example, the first sub-pixel and the second sub-pixel included in the plurality of sub-pixels may be adjacent sub-pixels provided side by side along the second direction in one pixel unit, or two sub-pixels that are spaced apart from each other and provided side by side along the second direction in one pixel unit. The embodiments of the present disclosure are not limited to this, as long as the first sub-pixel and the sub-pixel are in the same pixel unit.

For example, in one example, the first sub-pixel and the second sub-pixel are respectively the red sub-pixel and the green sub-pixel, correspondingly, the first effective light-emitting region is the red light-emitting region, and the second effective light-emitting region is the green light-emitting region. Generally, the emitting area of the red sub-pixel is larger than the emitting area of the green sub-pixel, that is, the area of the first effective light-emitting region is larger than the area of the second effective light-emitting region. By setting the area of the first light-shielding layer to be larger than the area of the second light-shielding layer, the opening ratio of the plurality of sub-pixels can be adjusted to improve the light mixing effect. Moreover, the manufacture process of the display substrate is simpler and the display substrate has higher light-emitting efficiency.

For example, the first light-shielding layer and the second light-shielding layer can be formed of the same material in the same process, and the material of the first light-shielding layer and the second light-shielding layer may be a metal material with light-shielding performance or other conductive materials with light-shielding performance, the embodiments of the present disclosure are not limited herein.

For example, in a case that the ratio M1 of a to b is less than 1.020, the ratio a of the area of the first light-shielding layer to the area of the first sub-pixel is too small, resulting in a higher opening rate of the first sub-pixel and a lower opening rate of the second sub-pixel, which leads to poor final color mixing effect. In a case that the ratio M1 of a to b is greater than 1.120, the ratio a of the area of the first light-shielding layer to the area of the first sub-pixel is larger, resulting in a smaller opening ratio of the first sub-pixel and a larger opening ratio of the second sub-pixel, which leads to poor final color mixing effect.

For example, in one example, the opening ratio of the first sub-pixel is n1 (1-a), the opening ratio of the second sub-pixel is n2 (1-b), (n1/n2) (1-a)/(1-b)=M2 * K1 * K2, it can be derived that (1-a)/(1-b)=(n2/n1) M2 * K1 * K2, where K1 is the ratio of the initial brightness of the second sub-pixel to the initial brightness of the first sub-pixel, and K2 is the ratio of the lifetime of the second sub-pixel to the lifetime of the first sub-pixel, n1 is the ratio of the area of the opening region in the first sub-pixel to the area of the part in the first sub-pixel other than the region shielded by the first light-shielding layer, n2 is the ratio of the area of the opening region in the second sub-pixel to the area of the part in the second sub-pixel other than the region shielded by the second light-shielding layer. The value of (n2/n1) M2 ranges from 1.000 to 1.130, and the value of (1-a)/(1-b) ranges from 0.877 to 0.997.

For example, the above formula (n1/n2) (1-a)/(1-b) = M2 * K1 * K2 can be derived use the following formula: (Initial brightness of the sub-pixel * opening ratio of the pixel/initial brightness of the pixel unit) * luminescence lifetime of the sub-pixel=$C_{constant}$. The specific derivation process can be found in the relevant description of the display substrate above, which will not be repeated here.

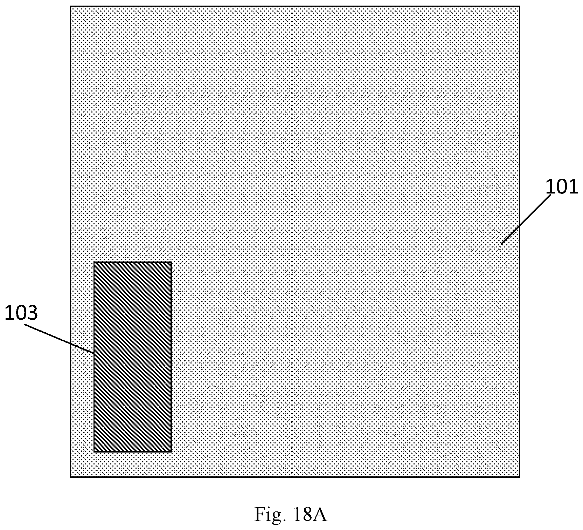

For example, the process of forming one sub-pixel (such as the first sub-pixel) of the plurality of sub-pixels is shown in Fig. 18A to Fig. 18H, Fig. 18A to Fig. 18H illustrate the one sub-pixel being the first sub-pixel as an example, that is, Fig. 18A to Fig. 18H are diagrams of the formation process of the first sub-pixel provided by at least one embodiment of the present disclosure.

For example, as shown in Fig. 18A, a first base substrate 101 is provided and a first light-shielding layer 103 is formed on the first base substrate 101. For example, materials of the first base substrate 101 and the first light-shielding layer 103 can be referred to in the relevant descriptions of the display substrate mentioned above, which will not be repeated herein.

For example, a first light-shielding layer thin film may be formed on the first base substrate 101. The process of forming the first light-shielding layer thin film includes evaporating a metal material with light-shielding properties or forming the first light-shielding layer thin film by magnetron sputtering, and then patterning the first light-shielding layer thin film by photolithography to form the first light-shielding layer 103.

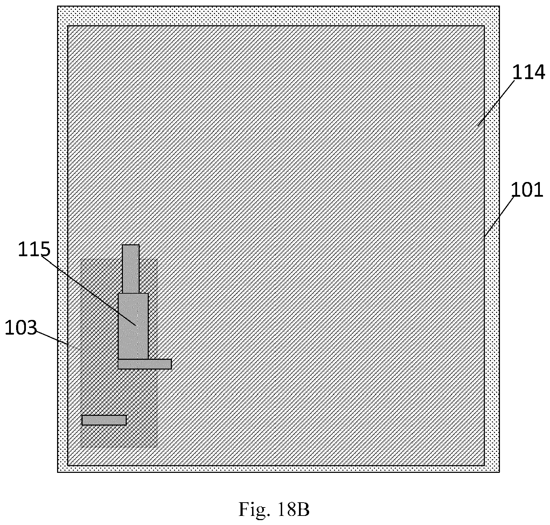

For example, as shown in Fig. 18B, a buffer layer 114 and an active layer 115 are sequentially formed on the first light-shielding layer 103.

For example, the buffer layer 114 covers the entire first base substrate 101, and the orthographic projection of the active layer 115 on the first base substrate 101 overlaps with the orthographic projection of the first light-shielding layer 103 on the first base substrate 101. For example, the overlapping area of the orthographic projection of the active layer 115 on the first base substrate 101 and the orthographic projection of the first light-shielding layer 103 on the first base substrate 101 is 75% to 95% of the area of the orthographic projection of the active layer 115 on the first base substrate 101. For example, the overlapping area of the orthographic projection of the active layer 115 on the first base substrate 101 and the orthographic projection of the first light-shielding layer 103 on the first base substrate 101 is more than 90% of the area of the orthographic projection of the active layer 115 on the first base substrate 101.

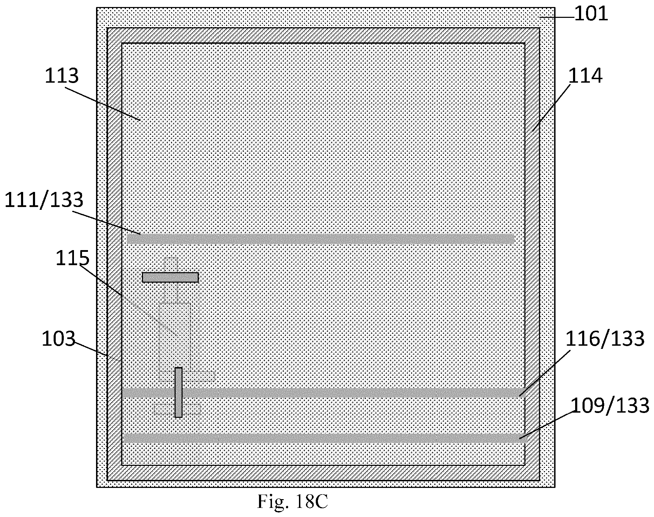

For example, as shown in Fig. 18C, a gate insulation layer thin film and a first metal layer thin film are formed on the side of the active layer 115 away from the first base substrate 101. The gate insulation layer thin film and the first metal layer thin film are subjected to a patterning process to form a gate insulation layer 113 and a first metal layer 133. The first metal layer 133 includes a second power voltage line 111, a first gate line 116, and a second sensing line 109.

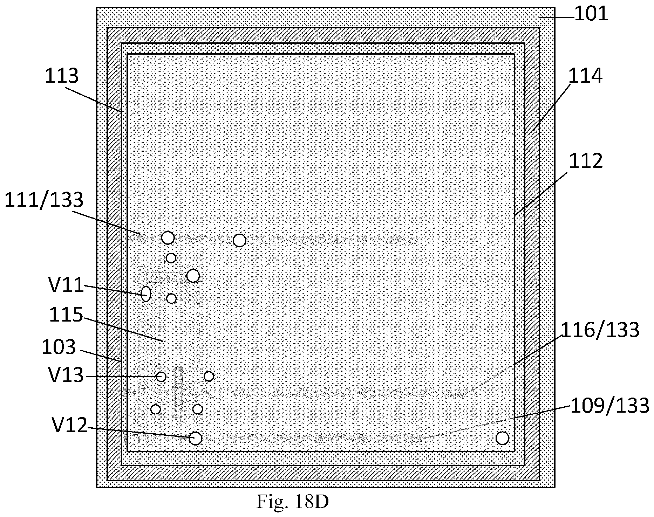

For example, as shown in Fig. 18D, an interlayer insulation layer 112 is formed on the side of the first metal layer 133 away from the first base substrate 101, and a first via V11 penetrating the interlayer insulation layer 112, the gate insulation layer 113, and the buffer layer 114 is formed, a second via V12 penetrating the interlayer insulation layer 112 is formed, and a plurality of third vias V13 penetrating the interlayer insulation layer 112 and the gate insulation layer 113 are formed.

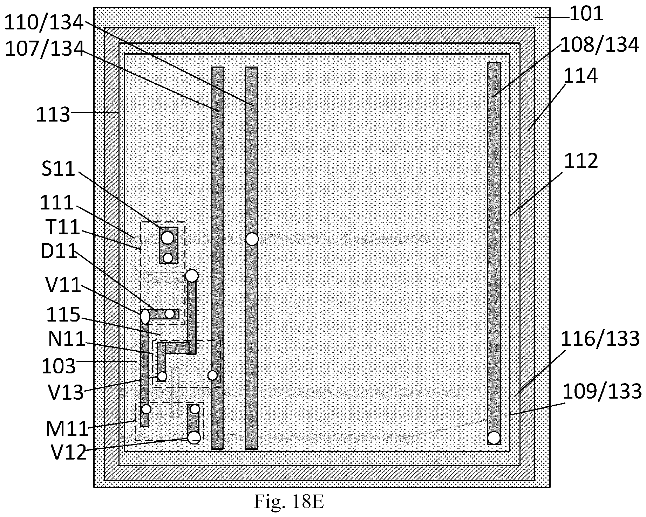

For example, as shown in Fig. 18E, a second metal layer 134 is formed on the side of the interlayer insulation layer 112 away from the first base substrate 101. The second metal layer 134 includes a first power voltage line 110, a data line 107, a first sensing line 108, a first source electrode S11 of the first driving transistor T11, a first drain electrode D11 of the first driving transistor T11, a source electrode of the first switching transistor N11, and a drain electrode of the first switching transistor N11, a source electrode of the first sensing transistor M11 and a drain electrode of the first sensing transistor M11. The first source electrode S11 of the first driving transistor T11 is connected to the second power voltage line 111 through the second via V12. The drain electrode of the first sensing transistor M11 is connected to the second sensing line 109 through the second via V12. The first drain electrode D11 is connected to the first light-shielding layer 103 of the first driving transistor T11 through the first via V11. The first source electrode S11 of the first driving transistor T11 is connected to the active layer 115 through the third via V13, the first drain electrode D11 of the first driving transistor T11 is connected to the active layer 115 through the third via V13, the source electrode of the first switching transistor N11 is connected to the active layer 115 through the third via V13, and the drain electrode of the first switching transistor N11 is connected to the active layer 115 through the third via V13, the source electrode of the first sensing transistor M11 is connected to the active layer 115 through the third via V13, and the drain electrode of the first sensing transistor M11 is connected to the active layer 115 through the third via V13.

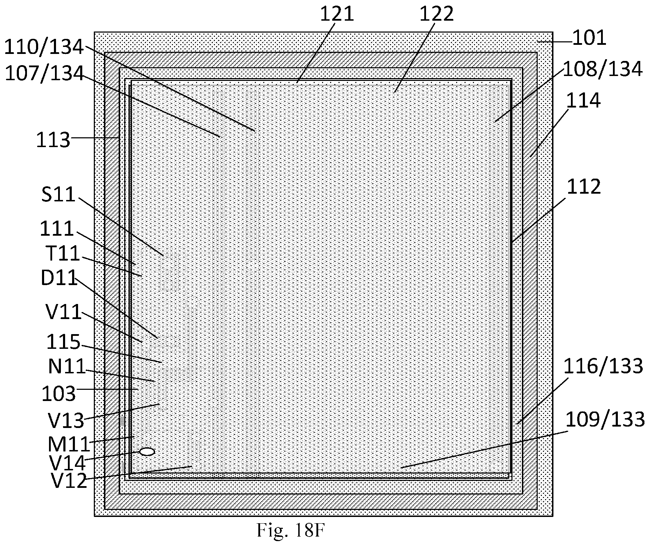

For example, as shown in Fig. 18F, a passivation layer 121 and a planarization layer 122 are formed on the side of the second metal layer 134 away from the first base substrate 101, and a fourth via V14 penetrating the passivation layer 121 and the planarization layer 122 is formed. For example, the fourth via V14 may be an anode via, that is, the subsequently formed anode can be electrically connected to the second metal layer 134 through the fourth via V14.

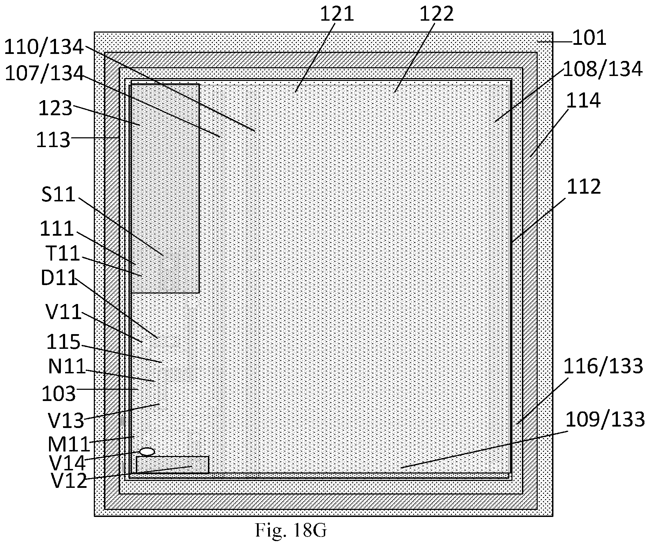

For example, as shown in Fig. 18G, a first electrode 123 is formed on the side of the planarization layer 122 away from the first base substrate 101. The first electrode 123 is an anode and is electrically connected to the second metal layer 134 through the fourth via V14.

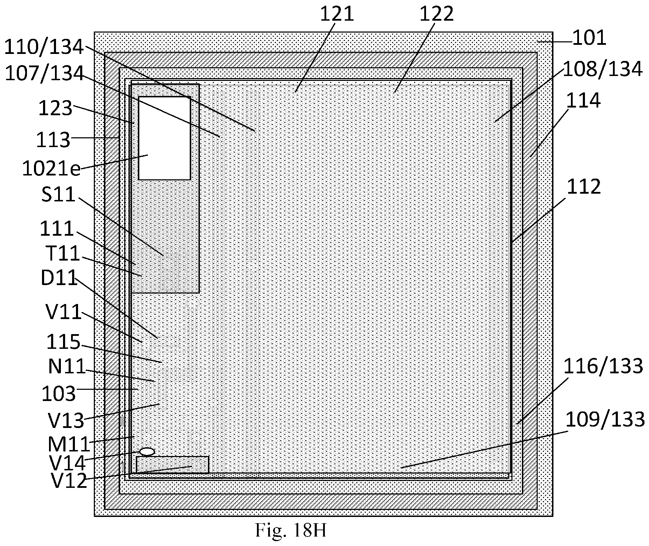

For example, as shown in Fig. 18H, a first color light-emitting unit 1021e is formed on the side of the first electrode 123 away from the first base substrate 101, the first color light-emitting unit 1021e includes a first color light-emitting layer. For example, the first color light-emitting layer is a light-emitting layer that emits red light.

For example, in one example, the formation process of the second sub-pixel, the third sub-pixel, and the fourth sub-pixel located in the same pixel unit as the first sub-pixel can be referred to in the relevant descriptions of the formation process of the first sub-pixel mentioned above, which will not be repeated herein.

For example, in one example, the second sub-pixel, the third sub-pixel, and the fourth sub-pixel may be green sub-pixel, blue sub-pixel, and white sub-pixel, respectively. The structure of the formed display substrate can be referred to in the relevant description of the display substrate mentioned above, which will not be repeated here.

The display substrate and the manufacture method thereof and the display device provided by at least one embodiment of the present disclosure have at least one of the beneficial technical effects as follows.

(1) The display substrate provided by at least one embodiment of the present disclosure adjusts the opening ratio of different sub-pixels by designing the size of the light-shielding layer corresponding to the different sub-pixels, making the entire process of manufacturing the display substrate simpler.

(2) In the display substrate provided by at least one embodiment of the present disclosure, the ratio M1 of the ratio a of the area of the first light-shielding layer to the area of the first sub-pixel to the ratio b of the area of the second light-shielding layer to the area of the second sub-pixel is set to range from 1.020 to 1.120, which can improve the final color mixing effect.

(3) The display substrate provided by at least one embodiment of this disclosure can adjust the opening ratio of the first sub-pixel and the second sub-pixel to achieve better light mixing effect by setting the area of the first light-shielding layer to be larger than the area of the second light-shielding layer. Moreover, the process of manufacturing the display substrate is simpler, and the display substrate has higher light-emitting efficiency.

The following several statements should be noted:

(1) The accompanying drawings involve only the structure(s) in connection with the embodiment(s) of the present disclosure, and other structure(s) can be referred to common design(s).

(2) For clarity, in accompanying drawings for illustrating the embodiment(s) of the present disclosure, the thickness of a layer or a region may be enlarged or reduced, that is, the drawings are not drawn in an actual scale.

(3) In case of no conflict, embodiments of the present disclosure and the features in the embodiments may be mutually combined to obtain new embodiments.

The above descriptions are only specific embodiments of the present disclosure, but the protection scope of the present disclosure is not limited thereto, the protection scope of the present disclosure should be determined by the protection scope of the claims.

## Claims

1. A display substrate, comprising:

   a first base substrate; and
   a plurality of sub-pixels on the first base substrate, wherein the plurality of sub-pixels comprise a first sub-pixel and a second sub-pixel;
   wherein the first sub-pixel comprises a first pixel circuit and a first effective light-emitting region;
   the second sub-pixel comprises a second pixel circuit and a second effective light-emitting region;
   a first light-shielding layer is provided between the first pixel circuit and the first base substrate, and an orthographic projection of the first light-shielding layer on the first base substrate at least partially overlaps with an orthographic projection of the first pixel circuit on the first base substrate;
   a second light-shielding layer is provided between the second pixel circuit and the first base substrate, and an orthographic projection of the second light-shielding layer on the first base substrate at least partially overlaps with an orthographic projection of the second pixel circuit on the first base substrate;
   a wavelength of light emitted from the first effective light-emitting region is greater than a wavelength of light emitted from the second effective light-emitting region, a ratio of an area of the first light-shielding layer to an area of the first sub-pixel is a, a ratio of an area of the second light-shielding layer to an area of the second sub-pixel is b, and a ratio M1 of a to b ranges from 1.020 to 1.120.

2. The display substrate according to claim 1, wherein the area of the first sub-pixel is equal to the area of the second sub-pixel; on a plane parallel to a main surface of the first base substrate, a ratio of the area of the first light-shielding layer to the area of the second light-shielding layer is equal to M1.

3. The display substrate according to claim 1 or 2, wherein an opening ratio of the first sub-pixel is n1(1-a), and an opening ratio of the second sub-pixel is n2(1-b);
   (1-a)/(1-b)=(n2/n1) M2 * K1 * K2, where K1 is a ratio of an initial brightness of the second sub-pixel to an initial brightness of the first sub-pixel, K2 is a ratio of a lifetime of the second sub-pixel to a lifetime of the first sub-pixel, and n1 is a ratio of an area of an opening region in the first sub-pixel to an area of a portion in the first sub-pixel other than a region shielded by the first light-shielding layer, n2 is a ratio of an area of an opening region in the second sub-pixel to an area of a portion in the second sub-pixel other than a region shielded by the second light-shielding layer, a value of (n2/n1)M2 ranges from 1.000 to 1.130, and a value of (1-a)/(1-b) ranges from 0.877 to 0.997.

4. The display substrate according to any one of claims 1 to 3, wherein the plurality of sub-pixels further comprise a third sub-pixel;

the third sub-pixel comprises a third pixel circuit and a third effective light-emitting region;
a third light-shielding layer is provided between the third pixel circuit and the first base substrate, and an orthographic projection of the third light-shielding layer on the first base substrate at least partially overlaps with an orthographic projection of the third pixel circuit on the first base substrate;
a wavelength of light emitted from the third effective light-emitting region is greater than the wavelength of the light emitted from the second effective light-emitting region, on a plane parallel to a main surface of the first base substrate, an area ratio c of the third light-shielding layer is equal to a ratio of an area of the third light-shielding layer to an area of the third sub-pixel, and an opening ratio of the third sub-pixel is n3(1-c);

$$(1-c)/(1-b)=(n2/n3)\ M3\ *\ K3\ *\ K4,$$

where K3 is a ratio of an initial brightness of the second sub-pixel to an initial brightness of the third sub-pixel, K4 is a ratio of a lifetime of the second sub-pixel to a lifetime of the third sub-pixel, n3 is a ratio of an area of an opening region in the third sub-pixel to an area of a portion of the third sub-pixel other than a region shielded by the third light-shielding layer, a value of (n2/n3) M3 ranges from 0.190 to 0.260, and a value of (1-c)/(1-b) ranges from 1.002 to 1.350.

5. The display substrate according to claim 4, wherein the plurality of sub-pixels further comprise a fourth sub-pixel;

the fourth sub-pixel comprises a fourth pixel circuit and a fourth effective light-emitting region;
a fourth light-shielding layer is provided between the fourth pixel circuit and the first base substrate, and an orthographic projection of the fourth light-shielding layer on the first base substrate at least partially overlaps with an orthographic projection of the fourth pixel circuit on the first base substrate;
a wavelength of light emitted from the fourth effective light-emitting region is greater than the wavelength of the light emitted from the second effective light-emitting region, on the plane parallel to the main surface of the first base substrate, an area ratio d of the fourth light-shielding layer is equal to a ratio of an area of the fourth light-shielding layer to an area of the fourth sub-pixel, an opening ratio n4(1-d) of the fourth sub-pixel ranges from 0.230 to 0.950, where n4 is a ratio of an area of an opening region in the fourth sub-pixel to an area of a portion in the fourth sub-pixel other than a region shielded by the fourth light-shielding layer.

6. The display substrate according to claim 4, wherein the first sub-pixel further comprises a first light-emitting element, the first pixel circuit controls the first light-emitting element to emit light, and a color of light emitted by the first light-emitting element is same as a color of the light emitted from the first effective light-emitting region;

the second sub-pixel further comprises a second light-emitting element, the second pixel circuit controls the second light-emitting element to emit light, and a color of light emitted by the second light-emitting element is same as a color of the light emitted from the second effective light-emitting region; and
the third sub-pixel further comprises a third light-emitting element, the third pixel circuit controls the third light-emitting element to emit light, and a color of light emitted by the third light-emitting element is same as a color of the light emitted from the third effective light-emitting region.

7. The display substrate according to claim 5, wherein the first sub-pixel further comprises a first light-emitting element, and the first pixel circuit controls the first light-emitting element to emit light;

the second sub-pixel further comprises a second light-emitting element, and the second pixel circuit controls the second light-emitting element to emit light;
the third sub-pixel further comprises a third light-emitting element, and the third pixel circuit controls the third light-emitting element to emit light;
the fourth sub-pixel further comprises a fourth light-emitting element, and the fourth pixel circuit controls the fourth light-emitting element to emit light;
the first light-emitting element, the second light-emitting element, the third light-emitting element, and the fourth light-emitting element are all white light-emitting elements, and a first filter layer, a second filter layer, a third filter layer, and a light transmitting layer are respectively provided on sides of the first light-emitting element, the second light-emitting element, the third light-emitting element, and the fourth light-emitting element away from the first base substrate respectively;

a color of light emitted from the first filter layer is same as a color of light emitted from the first effective light-emitting region, a color of light emitted from the second filter layer is same as a color of light emitted from the second effective light-emitting region, a color of light emitted from the third filter layer is same as a color of light emitted from the third effective light-emitting region, and a color of light emitted from the light transmitting layer is same as a color of light emitted from the fourth effective light-emitting region.

8. The display substrate according to claim 7, wherein a transmittance of a material of the first filter layer is $\lambda 1$, a transmittance of a material of the second filter layer is $\lambda 2$, a transmittance of a material of the third filter layer is $\lambda 3$, and a transmittance of a material of the light transmitting layer is $\lambda 4$;

a total transmittance of the first filter layer, the second filter layer, the third filter layer, and the light transmitting layer is $T(\lambda)$, and $T(\lambda) = n1(1-a)\lambda 1 + n2(1-b)\lambda 2 + n3(1-c)\lambda 3 + n4(1-d)X4$, and a value of $\lambda$ ranges from 0.260 to 0.950; a sum of the transmittances of the first filter layer, the second filter layer and the third filter layer and the transmittance of the light transmitting layer satisfy:

$$[n1(1-a)]\lambda 1 + n2(1-b)\lambda 2 + n3 (1-c)\lambda 3] : [n4(1-d)]\lambda 4] = 1:1,$$

and a value of n4(1-d) ranges from 0.260 to 0.860.

9. The display substrate according to claim 8, wherein on the plane parallel to the main surface of the first base substrate, a ratio of a total of an area of the first filter layer, an area of the second filter layer, an area of the third filter layer, and an area of the light transmitting layer to a total of an area of the first light-shielding layer, an area of the second light-shielding layer, an area of the third light-shielding layer, and an area of the fourth light-shielding layer ranges from 1.050 to 6.800.

10. The display substrate according to claim 9, wherein on the plane parallel to the main surface of the first base substrate, a ratio of an area of the first filter layer to an area of the first light-shielding layer ranges from 2.000 to 3.000.

11. The display substrate according to claim 9, wherein on the plane parallel to the main surface of the first base substrate, a ratio of an area of the second filter layer to an area of the second light-shielding layer ranges from 1.1074 to 1.6938.

12. The display substrate according to claim 5, further comprising: a data line and a first sensing line that extend along a first direction, and a second sensing line that extends along a second direction,

wherein the data line intersects with the second sensing line to define a plurality of pixel regions, each of the plurality of pixel regions comprises the sub-pixel; a first power voltage line parallel to the data line is provided between adjacent sub-pixels, and a second power voltage line parallel to the second direction is provided on a side of the first effective light-emitting region close to the first light-shielding layer, the second power voltage line intersects with the first power voltage line and is connected to a first drain electrode of a first driving transistor in the first pixel circuit, and an orthographic projection of the second power voltage line on the first base substrate overlaps with an orthographic projection of the first light-shielding layer on the first base substrate.

13. The display substrate according to claim 12, wherein the orthographic projection of the second power voltage line on the first base substrate overlaps with the orthographic projection of the fourth light-shielding layer on the first base substrate.

14. The display substrate according to claim 13, wherein the orthographic projection of the second power voltage line on the first base substrate overlaps with an orthographic projection of the third light-shielding layer on the first base substrate, and overlaps with an orthographic projection of the second light-shielding layer on the first base substrate.

15. The display substrate according to claim 14, wherein an overlapping area of the orthographic projection of the second power voltage line on the first base substrate and the orthographic projection of the first light-shielding layer on the first base substrate is greater than an overlapping area of the orthographic projection of the second power voltage line on the first base substrate and the orthographic projection of the second light-shielding layer on the first base substrate.

16. The display substrate according to claim 14, wherein an overlapping area of the orthographic projection of the second power voltage line on the first base substrate and the orthographic projection of the first light-shielding layer on the first base substrate is greater than an overlapping area of the orthographic projection of the second power voltage line on the first base substrate and the orthographic projection of the third light-shielding layer on the first base substrate.

17. The display substrate according to claim 14, wherein an overlapping area of the orthographic projection of the second power voltage line on the first base substrate and the orthographic projection of the first light-shielding layer on the first base substrate is greater than an overlapping area of the orthographic projection of the second power voltage line on the first base substrate and the orthographic projection of the fourth light-shielding layer on the first base substrate;

the overlapping area of the orthographic projection of the second power voltage line on the first base substrate and the orthographic projection of the fourth light-shielding layer on the first base substrate is greater than the overlapping area of the orthographic projection of the second power voltage line on the first base substrate and the orthographic projection of the third light-shielding layer on the first base substrate;
the overlapping area of the orthographic projection of the second power voltage line on the first base substrate and the orthographic projection of the third light-shielding layer on the first base substrate is greater than the overlapping area of the orthographic projection of the second power voltage line on the first base substrate and the orthographic projection of the second light-shielding layer on the first base substrate.

18. The display substrate according to claim 14, wherein in one first sub-pixel, an overlapping area of the orthographic projection of the second power voltage line on the first base substrate and the orthographic projection of the first light-shielding layer on the first base substrate ranges from 0.03 square micrometers to 0.30 square micrometers;

in one second sub-pixel, an overlapping area of the orthographic projection of the second power voltage line on the first base substrate and the orthographic projection of the fourth light-shielding layer on the first base substrate ranges from 0.02 square micrometers to 0.20 square micrometers;
in one third sub-pixel, an overlapping area of the orthographic projection of the second power voltage line on the first base substrate and the orthographic projection of the third light-shielding layer on the first base substrate ranges from 0 to 0.05 square micrometers; and
in one fourth sub-pixel, an overlapping area of the orthographic projection of the second power voltage line on the first base substrate and the orthographic projection of the second light-shielding layer on the first base substrate ranges from 0 to 0.08 square micrometers.

19. The display substrate according to claim 12, wherein the second power voltage line comprises a first portion and a second portion that are separated from each other, and the first portion and the second portion are connected to the first power voltage line through different via structures.

20. The display substrate according to claim 19, wherein the first portion is connected to the first drain electrode of the first driving transistor of the first pixel circuit and a second drain electrode of a second driving transistor of the second pixel circuit;

the second portion is connected to a third drain electrode of a third driving transistor of the third pixel circuit and a fourth drain electrode of a fourth driving transistor of the fourth pixel circuit.

21. The display substrate according to claim 19 or 20, wherein an extension direction of the first portion is parallel to an extension direction of the second portion, the first portion and the second portion extend in a straight line, and the first portion is on a side of the second portion close to the second sensing line.

22. The display substrate according to claim 21, wherein the first portion is connected to the first drain electrode and a middle region of the second drain electrode, and the second portion is connected to an edge of the third drain electrode away from the second sensing line and an edge of the fourth drain electrode away from the second sensing line.

23. The display substrate according to claim 20, wherein the first portion and the second portion both extend along a broken line, and the first portion is connected to an edge of the first drain electrode away from the second sensing line and a middle region of the second drain electrode; the second portion is connected to an edge of the third drain electrode away from the second sensing line and a middle region of the fourth drain electrode.

24. The display substrate according to claim 20, wherein the first drain electrode and the first light-shielding layer are connected through a first via that sequentially penetrates an interlayer insulation layer, a gate insulation layer, and a buffer layer.

25. The display substrate according to claim 12, further comprising a first gate line extending along the second direction and a first gate electrode extending from the first gate line towards a side of the second power voltage line, wherein a planar shape of the first light-shielding layer comprises a first sub-portion and a second sub-portion extending along the first direction, and a first distance between a first side of the first sub-portion close to the first gate line and the first gate line is greater than a second distance between a second side of the second sub-portion close to the first gate electrode and the first gate electrode.

26. The display substrate according to claim 25, further comprising a second gate line parallel to the first gate line, wherein the first gate electrode is configured as a gate electrode of a first switching transistor, the second gate line is configured as a gate electrode of a first sensing transistor of the first pixel circuit, a gate electrode of a second sensing transistor of the second pixel circuit, a gate electrode of a third sensing transistor of the third pixel circuit, and a gate electrode of a fourth sensing transistor of the fourth pixel circuit.

27. A display device, comprising the display substrate according to any one of claims 1 to 26 and a cover plate opposite to the display substrate,
wherein the cover plate comprises a second base substrate, and a quantum dot layer is provided on a side of the second base substrate close to the display substrate, the quantum dot layer comprises a plurality of quantum dot units, the plurality of quantum dot units correspond to a plurality of sub-pixels in one-to-one correspondence, a color of each of the plurality of quantum dot units is same as a color of a corresponding sub-pixel.

28. The display device according to claim 27, further comprising: a black matrix provided on the side of the second base substrate close to the display substrate, wherein the black matrix comprises a plurality of openings, and each of the plurality of quantum dot units is within one of the plurality of openings.

29. A manufacture method of a display substrate, comprising:

providing a first base substrate; and
forming a plurality of sub-pixels on the first base substrate, wherein forming the plurality of sub-pixels comprises forming a first sub-pixel and a second sub-pixel;
forming the first sub-pixel comprises forming a first pixel circuit and a first effective light-emitting region;
forming the second sub-pixel comprises forming a second pixel circuit and a second effective light-emitting region;
forming a first light-shielding layer between the first pixel circuit and the first base substrate, wherein an orthographic projection of the first light-shielding layer on the first base substrate at least partially overlaps with an orthographic projection of the first pixel circuit on the first base substrate;
forming a second light-shielding layer between the second pixel circuit and the first base substrate, wherein an orthographic projection of the second light-shielding layer on the first base substrate at least partially overlaps with an orthographic projection of the second pixel circuit on the first base substrate;
a wavelength of light emitted from the first effective light-emitting region is greater than a wavelength of light emitted from the second effective light-emitting region, a ratio of an area of the first light-shielding layer to an area of the first sub-pixel is a, a ratio of an area of the second light-shielding layer to an area of the second sub-pixel is b, and a ratio M1 of a to b ranges from 1.020 to 1.120.

30. The manufacture method according to claim 29, wherein an opening ratio of the first sub-pixel is n1(1-a), and an opening ratio of the second sub-pixel is n2(1-b);

$$(1\text{-}a)/(1\text{-}b)=(n2/n1)\ M2\ *\ K1\ *\ K2,$$

where K1 is a ratio of an initial brightness of the second sub-pixel to an initial brightness of the first sub-pixel, K2 is a ratio of a lifetime of the second sub-pixel to a lifetime of the first sub-pixel, and n1 is a ratio of an area of an opening region in the first sub-pixel to an area of a portion in the first sub-pixel other than a region shielded by the first light-shielding layer, n2 is a ratio of an area of an opening region in the second sub-pixel to an area of a portion in the second sub-pixel other than a region shielded by the second light-shielding layer, a value of (n2/n1)M2 ranges from 1.000 to 1.130, and a value of (1-a)/(1-b) ranges from 0.877 to 0.997.

Fig. 1

Fig. 2

Fig. 3

Fig. 4

Fig. 5

100

Fig. 6

100

Fig. 7

Fig. 8A

Fig. 8B

Fig. 9

Fig. 10

Fig. 11

Fig. 12

Fig. 13

Fig. 14

Fig. 15

Fig. 16

| Providing a first base substrate | S11 |

| Forming a plurality of sub-pixels on the first base substrate, in which forming the plurality of sub-pixels includes forming a first sub-pixel and a second sub-pixel | S12 |

| Forming the first sub-pixel includes forming a first pixel circuit and a first effective light-emitting region | S13 |

| Forming the second sub-pixel includes forming a second pixel circuit and a second effective light-emitting region | S14 |

| Forming a first light-shielding layer between the first pixel circuit and the first base substrate, in which an orthographic projection of the first light-shielding layer on the first base substrate at least partially overlaps with an orthographic projection of the first pixel circuit on the first base substrate | S15 |

| Forming a second light-shielding layer between the second pixel circuit and the first base substrate, and an orthographic projection of the second light-shielding layer on the first base substrate at least partially overlaps with an orthographic projection of the second pixel circuit on the first base substrate; a wavelength of light emitted from the first effective light-emitting region is greater than a wavelength of light emitted from the second effective light-emitting region, a ratio of an area of the first light-shielding layer to an area of the first sub-pixel is a, a ratio of an area of the second light-shielding layer to an area of the second sub-pixel is b, and a ratio M1 of a to b ranges from 1.020 to 1.120 | S16 |

Fig. 17

Fig. 18A

Fig. 18B

Fig. 18C

Fig. 18D

Fig. 18E

121 122
101
110/134
107/134
108/134
114
113
S11
112
111
T11
D11
V11
115
N11
103
V13
M11
116/133
V14
109/133
V12

Fig. 18F

121   122

110/134
107/134
123
113

S11
111
T11
D11
V11
115
N11
103
V13
M11
V14
V12

101
108/134
114
112
116/133
109/133

Fig. 18G

121   122

110/134
107/134
123
113
1021e
S11
111
T11
D11
V11
115
N11
103
V13
M11
V14
V12

101
108/134
114
112
116/133
109/133

Fig. 18H

## INTERNATIONAL SEARCH REPORT

| International application No. |
| --- |
| **PCT/CN2023/100570** |

**A. CLASSIFICATION OF SUBJECT MATTER**

H10K59/10(2023.01)i

According to International Patent Classification (IPC) or to both national classification and IPC

**B. FIELDS SEARCHED**

Minimum documentation searched (classification system followed by classification symbols)

IPC: H10K

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 显示, 像素, 遮光, 挡光, 屏蔽, 遮蔽, 光阻, 阻光, 面积, 尺寸, 大小, 混色, 开口率, display, pixel, shield, prevent, block, light, area, size, color mixing, aperture, ratio

**C. DOCUMENTS CONSIDERED TO BE RELEVANT**

| Category* | Citation of document, with indication, where appropriate, of the relevant passages | Relevant to claim No. |
| --- | --- | --- |
| PX | CN 114927553 A (BEIJING BOE TECHNOLOGY DEVELOPMENT CO., LTD. et al.) 19 August 2022 (2022-08-19)<br>description, paragraphs [0004]-[0176], and figures 1-18H | 1-30 |
| A | KR 20160056401 A (LG DISPLAY CO., LTD.) 20 May 2016 (2016-05-20)<br>description, paragraphs [0017]-[0106], and figures 1-10 | 1-30 |
| A | CN 101710587 A (SAMSUNG ELECTRONICS CO., LTD.) 19 May 2010 (2010-05-19)<br>entire document | 1-30 |
| A | CN 106873277 A (WUHAN CHINA STAR OPTOELECTRONICS TECHNOLOGY CO., LTD.) 20 June 2017 (2017-06-20)<br>entire document | 1-30 |
| A | CN 112823422 A (BOE TECHNOLOGY GROUP CO., LTD. et al.) 18 May 2021 (2021-05-18)<br>entire document | 1-30 |
| A | CN 114709345 A (WUHAN TIANMA MICRO-ELECTRONICS CO., LTD.) 05 July 2022 (2022-07-05)<br>entire document | 1-30 |

☑ Further documents are listed in the continuation of Box C.     ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **16 July 2023** | **24 July 2023** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/100570**

**C.** **DOCUMENTS CONSIDERED TO BE RELEVANT**

| Category* | Citation of document, with indication, where appropriate, of the relevant passages | Relevant to claim No. |
|---|---|---|
| A | KR 20210086056 A (LG DISPLAY CO., LTD.) 08 July 2021 (2021-07-08)<br>entire document | 1-30 |

Form PCT/ISA/210 (second sheet) (July 2022)

**INTERNATIONAL SEARCH REPORT**
Information on patent family members

International application No.

**PCT/CN2023/100570**

| Patent document cited in search report | | | Publication date (day/month/year) | Patent family member(s) | | | Publication date (day/month/year) |
|---|---|---|---|---|---|---|---|
| CN | 114927553 | A | 19 August 2022 | CN | 114927553 | B | 01 November 2022 |
| KR | 20160056401 | A | 20 May 2016 | KR | 102208431 | B1 | 27 January 2021 |
| CN | 101710587 | A | 19 May 2010 | KR | 20100032187 | A | 25 March 2010 |
| | | | | KR | 101545315 | B1 | 20 August 2015 |
| | | | | US | 2010065849 | A1 | 18 March 2010 |
| | | | | US | 7968891 | B2 | 28 June 2011 |
| | | | | CN | 101710587 | B | 12 February 2014 |
| CN | 106873277 | A | 20 June 2017 | WO | 2018188159 | A2 | 18 October 2018 |
| | | | | WO | 2018188159 | A3 | 29 November 2018 |
| | | | | US | 2018301468 | A1 | 18 October 2018 |
| | | | | US | 10347664 | B2 | 09 July 2019 |
| | | | | CN | 106873277 | B | 08 November 2019 |
| CN | 112823422 | A | 18 May 2021 | | None | | |
| CN | 114709345 | A | 05 July 2022 | | None | | |
| KR | 20210086056 | A | 08 July 2021 | US | 2021202589 | A1 | 01 July 2021 |
| | | | | KR | 20210086057 | A | 08 July 2021 |
| | | | | CN | 113130578 | A | 16 July 2021 |
| | | | | US | 11627690 | B2 | 11 April 2023 |

Form PCT/ISA/210 (patent family annex) (July 2022)

51

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210823111